(19) Europäisches Patentamt

European Patent Office

Office européen des brevets

(11) **EP 0 593 333 B1**

(12) **FASCICULE DE BREVET EUROPEEN**

(45) Date de publication et mention
de la délivrance du brevet:
**13.09.2000 Bulletin 2000/37**

(51) Int. Cl.⁷: **H01L 39/10**

(21) Numéro de dépôt: **93402425.8**

(22) Date de dépôt: **04.10.1993**

(54) **Cellule de détection, détecteur, capteur et spectroscope**

Detektorzelle, Detektor, Sensor für Spektroskop

Detector cell, detector, sensor for spectroscope

(84) Etats contractants désignés:
**DE FR GB IT**

(30) Priorité: **05.10.1992 FR 9211753**

(43) Date de publication de la demande:
**20.04.1994 Bulletin 1994/16**

(73) Titulaire:
**AGENCE SPATIALE EUROPEENNE**
**F-75738 Paris Cedex 15 (FR)**

(72) Inventeurs:
• **Perryman, Michael Anthony Charles**
**NL-2311 BJ Leiden (NL)**
• **Peacock, Anthony**
**NL-2211 DD Noordwijkerhout (NL)**
• **Foden, Clare Louise**
**NL-2518 AM Den Haag (NL)**

(74) Mandataire: **Orès, Bernard et al**
**Cabinet ORES**
**6, Avenue de Messine**
**75008 Paris (FR)**

(56) Documents cités:
**EP-A- 0 375 465**

• **NUCLEAR INSTRUMENTS & METHODS IN PHYSICS RESEARCH vol. A313, no. 1 , 1 Mars 1992 , AMSTERDAM NL pages 173 - 195 RANDO N. ET AL 'The properties of niobium superconducting tunneling junctions as X-ray detectors.'**
• **IEEE TRANSACTIONS ON APPLIED SUPERCONDUCTIVITY vol. 3, no. 1 , Mars 1993 , NEW YORK US pages 2080 - 2083 RANDO N. ET AL 'Highly collimated photon detection using strongly coupled superconducting tunnel junctions.' & APPLIED SUPERCONDUCTIVITY CONFERENCE, 23-28 Août 1992 , CHICAGO US**
• **IEEE TRANSACTIONS ON MAGNETICS vol. 25, no. 2 , Mars 1989 , NEW YORK ,US pages 1351 - 1353 GARE P. ET AL 'The detection of 6 kev X-rays with Nb junctions'**
• **NUCLEAR INSTRUMENTS & METHODS IN PHYSICS RESEARCH vol. A288, no. 2,3 , 15 Mars 1990 , AMSTERDAM NL pages 541 - 548 HEBRANK F. ET AL 'Nb-AlOx-Nb tunnel junctions as detectors for ionizing radiation'**

**Description**

La présente invention se rapporte principalement à une cellule de détection, à un détecteur matriciel mettant en oeuvre de telles cellules, à un capteur comportant un tel détecteur et à un spectroscope comportant un tel capteur.

Il est connu de réaliser le comptage de photons appartenant à la bande des rayons X, c'est-à-dire la détection des photons X individuels, mettant en oeuvre une jonction de deux électrodes supraconductrices en niobium superposées, séparées par une barrière en Al-Al $O_x$-Al. Ces dispositifs décrits dans N. Rando, A. Peacock, A. van Dordrecht, C. Foden, R. Engelhardt, B.G. Taylor, P. Garé, J. Lumley et C. Pereira, Nucl. Instr. Meth. in Phys. Res. A 313 (1992) 173, ont un rendement quantique faible compris entre 5 et 25 %. Ces dispositifs ne sont pas du tout sensibles aux photons de plus basse énergie individuels, comme par exemple les photons visibles ou ultraviolets.

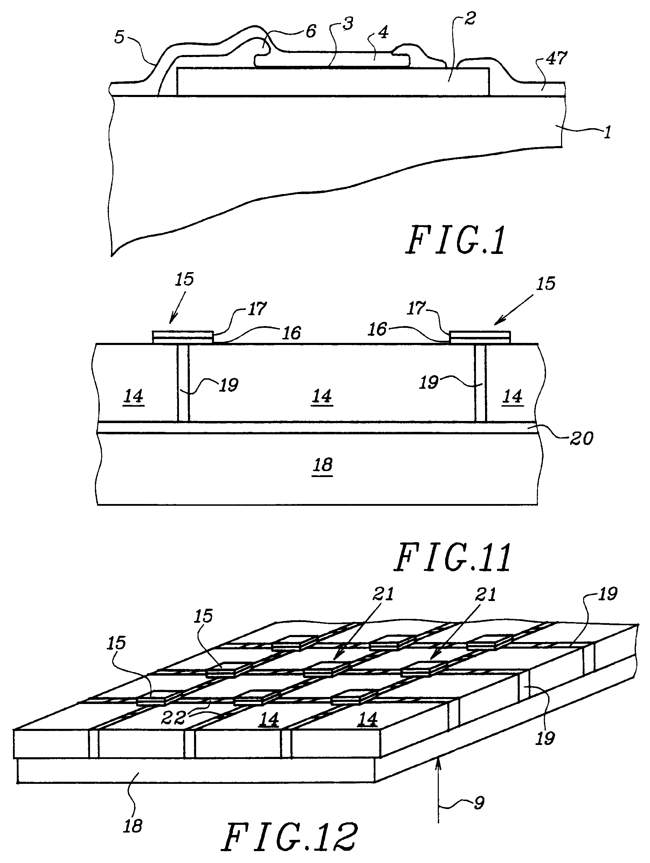

La structure de tels dispositifs sera brièvement décrite en référence à la figure 1.

D'autre part, le comptage de photons visibles ou ultraviolets a été réalisé avec, par exemple, des amplificateurs de lumière à micro-canaux. Ces dispositifs ont un rendement quantique faible et ne sont, de plus, efficaces que dans des bandes passantes relativement étroites.

Les dispositifs de comptage de photons à amplificateur de lumière ont une faible résolution temporelle et ne présentent aucune résolution spectrale.

M. Kurakado, Nucl. Instr. Meth. in Phys. Res. A 314 (1992) 252 et Journal of Applied Physics, vol.59, no.11, p. 3807-14 décrivent un détecteur optique analogique à supraconducteur. Contrairement au dispositif de comptage de photons, un détecteur analogique permet de mesurer les effets résultant des interactions collectives entre la partie sensible du détecteur et un grand nombre de photons optiques.

Ce type de détecteur ne peut donc avoir aucune résolution temporelle quant à l'arrivée des divers photons individuels. De même, il est impossible de connaître l'énergie de chaque photon (pas de résolution spectrale).

C'est par conséquent un but de la présente invention d'offrir une cellule de comptage de photons dans une large bande et notamment dans une bande s'étendant de l'infrarouge à l'ultraviolet.

C'est également un but de la présente invention d'offrir une cellule de comptage de photons présentant une grande efficacité quantique.

C'est aussi un but de la présente invention d'offrir une cellule de comptage de photons présentant une grande résolution temporelle.

C'est également un but de la présente invention d'offrir une cellule de comptage de photons présentant une résolution spectrale.

C'est aussi un but de la présente invention d'offrir un détecteur comportant au moins une, de préférence une pluralité de telles cellules.

C'est également un but de la présente invention d'offrir un tel détecteur comportant une matrice de telles cellules présentant une résolution spatiale.

C'est aussi un but de la présente invention d'offrir un capteur comportant un tel détecteur présentant un rapport signal/bruit élevé.

C'est également un but de la présente invention d'offrir un spectroscope très sensible comportant un tel capteur.

C'est aussi un but de la présente invention d'offrir un interféromètre sensible permettant de recueillir des données précises sur des corps célestes, la précision des données recueillies n'étant pas perturbée par l'agitation des couches de l'atmosphère (détection cohérente en deux points distants).

Ces buts sont atteints en mettant en oeuvre une cellule de détection telle que définie dans la revendication 1 comportant un élément supraconducteur, notamment l'élément photosensible dans lequel l'énergie de chaque quasi particule provenant de la paire de Cooper brisée diminue lors d'interactions entraînant une multiplication du nombre de quasi particules, ce qui augmente de manière extrêmement importante la probabilité de détection de l'interaction entre un photon et l'élément photosensible.

Selon l'invention, l'on met en oeuvre une cellule de détection comportant un élément sensible supraconducteur dont la surface est importante par rapport à la surface d'une ou, avantageusement, des jonction(s) de détection à effet tunnel.

Selon l'invention l'on utilise des jonctions supraconductrices à effet tunnel rapproché permettant d'augmenter la résolution spatiale et la résolution temporelle de la cellule.

Des canaux supraconducteurs, ayant une bande interdite de 2 $\Delta$, moins large que celle de l'élément sensible, canalisent des quasi particules à détecter vers les jonctions de détection.

L'invention a principalement pour objet une cellule de détection de photons comportant un élément supraconducteur en niobium sensible au photon du rayonnement à détecter ou à des phonons engendrés par un tel photon, par séparation de la paire de Cooper en quasi-particules et une jonction supraconductrice à effet tunnel comprenant une électrode supraconductrice, l'élément supraconducteur photosensible ayant des caractéristiques à la température de travail, de largeur de bande interdite du spectre d'excitation 2 $\Delta$ et d'épaisseur permettant une baisse de l'énergie de chaque quasi particule issue de la paire de Cooper brisée avec multiplication du nombre de quasi-particules par un facteur compris entre 100 et 1000 dans le spectre allant du proche infrarouge à l'ultraviolet et en ce qu'elle est délimitée par une pluralité de jonctions supraconductrices à effet tunnel espacées, réparties à la périphérie de la cellule,

caractérisée en ce que la cellule comporte à la périphérie, des parois aboutissant aux jonctions supraconductrices à effet tunnel, en un matériau supraconducteur, notamment en Al, dont la largeur de la bande interdite du spectre d'excitation 2 $\Delta_2$ est inférieure à la largeur 2 $\Delta_1$ de la bande interdite du spectre d'excitation du matériau de l'élément sensible, de façon à ce que lesdites parois forment des canaux pour canaliser les quasi particules vers les jonctions supraconductrices à effet tunnel et que le nombre de quasi particules augmente après le passage d'une quasi particule de l'élément sensible dans une paroi.

L'invention a aussi pour objet une cellule, caractérisée en ce que les parois comportent des discontinuités, de préférence à mi-distance entre deux jonctions supraconductrices à effet tunnel adjacentes.

L'invention a également pour objet une cellule selon l'une quelconque des revendications précédentes, caractérisée en ce que l'élément sensible a une faible épaisseur et est déposé sur un substrat transparent au rayonnement électromagnétique à capter.

L'invention a aussi pour objet une cellule, caractérisée en ce qu'elle comporte une couche de faible épaisseur absorbant le rayonnement à capter, ladite couche étant disposée entre le support et l'élément sensible.

L'invention a également pour objet une cellule, caractérisée en ce que la jonction supraconductrice à effet tunnel est en aluminium recouvert par une couche d'accrochage d'électrode en niobium.

L'invention a aussi pour objet un détecteur, caractérisé en ce qu'il comporte une pluralité de cellules, notamment détecteur linéaire comportant des cellules alignées selon un axe ou un détecteur matriciel comportant des cellules alignées selon des lignes et des colonnes.

L'invention a également pour objet un capteur comportant une cellule ou un détecteur, caractérisé en ce qu'il comporte un amplificateur à faible bruit connecté à chaque jonction supraconductrice à effet tunnel pour amplifier le courant des quasi particules passant par effet tunnel à travers la jonction.

L'invention a aussi pour objet un capteur, caractérisé en ce qu'il comporte des convertisseurs analogiques numériques assurant la numérisation des signaux délivrés par les amplificateurs et des moyens de traitement et/ou de stockage du signal numérisé.

L'invention a également pour objet un capteur, caractérisé en ce qu'il comporte des moyens de codage délivrant pour chaque valeur numérique l'intensité du signal délivré par un amplificateur, une information concernant la position de la jonction supraconductrice à effet tunnel concernée, le temps de réception et la valeur de l'intensité de courant amplifiée.

L'invention a aussi pour objet un capteur, caractérisé en ce qu'il comporte des moyens de mise en forme du signal et des moyens de calcul de détermination d'après la forme du signal transmis par les moyens de mise en forme du signal de la charge induite par le photon à détecter dans la jonction supraconductrice à effet tunnel.

L'invention a également pour objet un capteur, caractérisé en ce qu'il comporte des moyens d'échantillonnage du signal sur des intervalles de temps correspondant à la détection des photons successifs et des moyens pour en déduire l'énergie individuelle de chacun des photons.

L'invention a aussi pour objet un capteur, caractérisé en ce qu'il comporte des moyens d'intégration de la charge induite dans une jonction supraconductrice à effet tunnel par une pluralité de photons.

L'invention a également pour objet un spectroscope, caractérisé en ce qu'il comporte un capteur.

L'invention sera mieux comprise au moyen de la description ci-après et des figures annexées données comme des exemples non limitatifs, et sur lesquelles :

- la figure 1 est une coupe verticale d'un détecteur de type connu ;
- les figures 2 à 6 sont des schémas illustrant, de façon intuitive, les interactions intervenant dans le dispositif selon la présente invention ;
- la figure 7 est une coupe verticale d'un premier exemple de réalisation d'un détecteur selon la présente invention ;
- la figure 8 est une coupe verticale d'un deuxième exemple de réalisation d'un détecteur selon la présente invention ;
- la figure 9 est une coupe verticale d'un troisième exemple de réalisation d'un détecteur selon la présente invention ;
- la figure 10 est une coupe verticale de l'exemple préféré de réalisation d'un détecteur selon la présente invention ;
- la figure 11 est une coupe verticale d'un cinquième exemple de réalisation d'un détecteur selon la présente invention ;
- la figure 12 est une vue en perspective du détecteur de la figure 10 ;
- la figure 13 est un schéma d'un exemple de réalisation d'un capteur selon la présente invention ;
- la figure 14 est un schéma d'un exemple de réalisation d'un spectroscope selon la présente invention ;
- la figure 15 est un schéma d'un exemple de réalisation d'un interféromètre selon la présente invention ;
- la figure 16 est une coupe verticale d'un sixième exemple de réalisation d'un détecteur selon la présente invention ;

- la figure 17 est une coupe verticale d'un septième exemple de réalisation des détecteurs selon la présente invention ;
- la figure 18 est un schéma électrique d'un premier exemple de l'amplificateur susceptible d'être mis en oeuvre dans le détecteur selon la présente invention ;
- la figure 19 illustre le traitement du signal effectué par l'amplificateur de la figure 18 ;
- la figure 20 est un schéma d'un deuxième exemple de réalisation de l'amplificateur susceptible d'être mis en oeuvre dans un détecteur selon la présente invention ;
- la figure 21 comporte six courbes illustrant le traitement du signal par l'amplificateur de la figure 20 ;
- la figure 23 est un schéma d'un troisième exemple de réalisation de l'amplificateur selon l'invention ;
- la figure 24 comporte trois courbes illustrant le traitement du signal par l'amplificateur de la figure 23 ;
- la figure 25 est une courbe illustrant le courant en fonction de la tension de polarisation d'un exemple de réalisation d'un détecteur selon la présente invention ;
- la figure 26 illustre la réponse en fonction de la fréquence d'un détecteur selon la présente invention ;
- la courbe 27 illustre le niveau du signal pour deux paquets de photons correspondant à deux longueurs d'ondes différentes comparé au bruit du système ;
- la figure 28 illustre la charge électrique engendrée dans un détecteur selon la présente invention par des paquets de photons ;
- la figure 29 est un schéma illustrant, de façon intuitive, l'interaction intervenant dans le dispositif selon la présente invention.

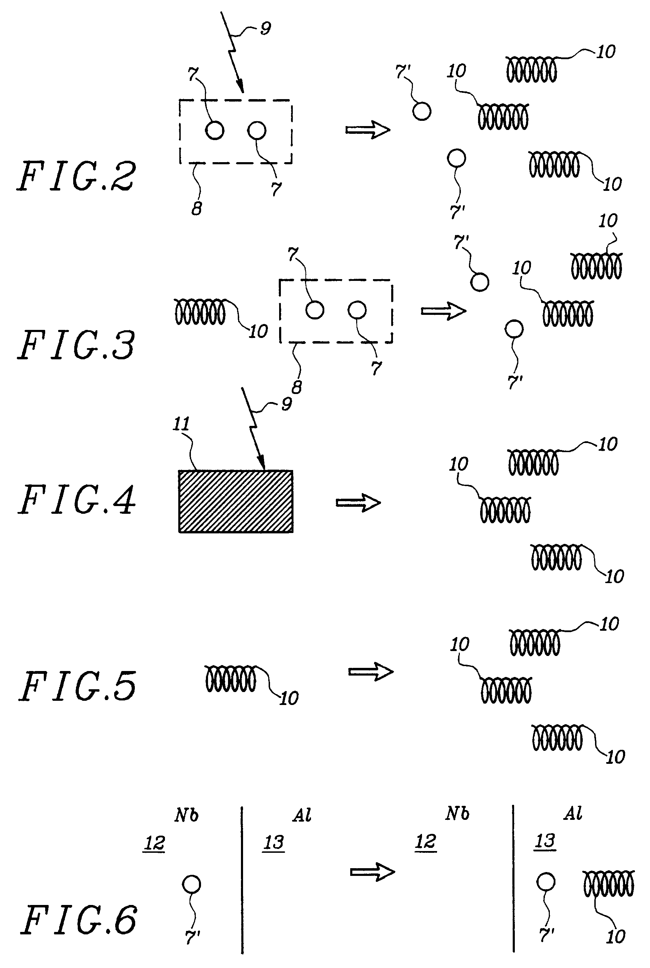

Sur les figures 2 à 29, l'on a utilisé les mêmes références pour désigner les mêmes éléments.

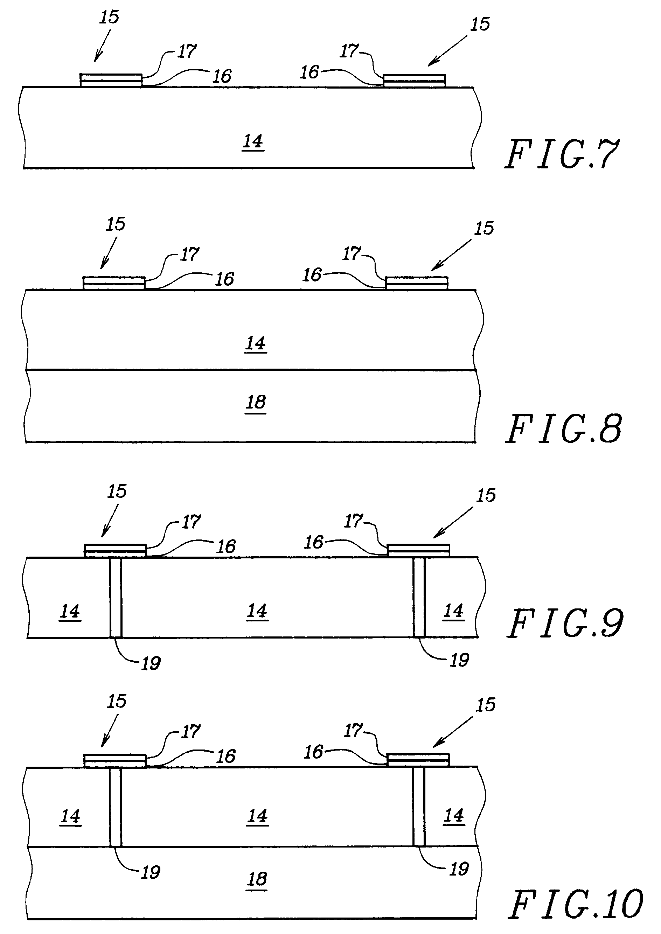

Pour des raisons de clarté, sur les figures 7 à 11, l'échelle verticale n'a pas été respectée. Egalement, la séparation entre les jonctions 15 a été donnée à titre d'exemple non limitatif.

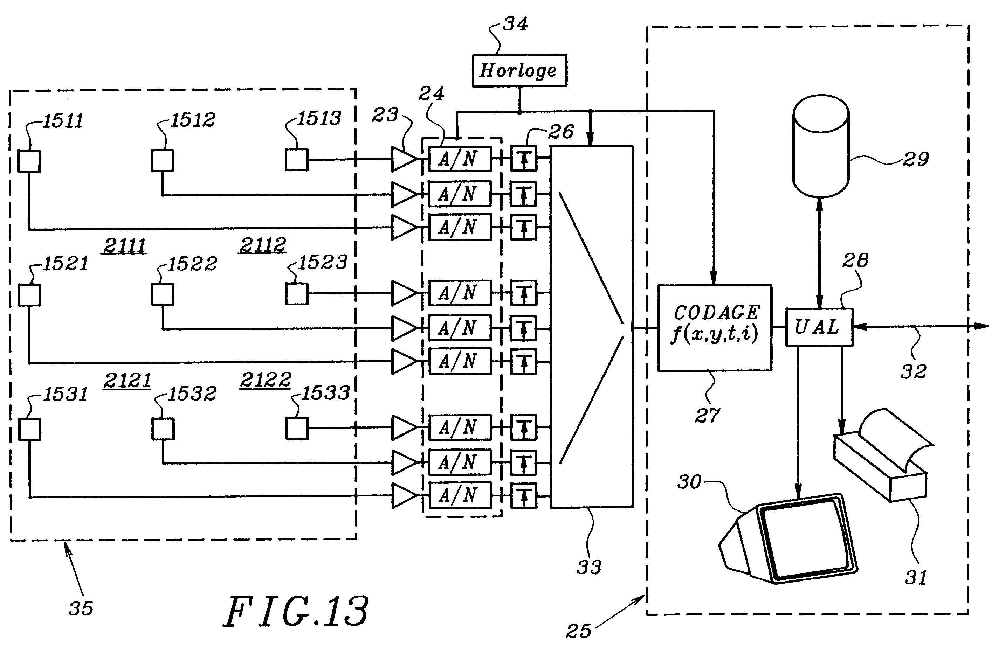

Nous allons maintenant, en référence à la figure 1, décrire brièvement la structure d'un capteur de type connu, en référence aux figures 2 à 6, indiquer intuitivement les interactions mises en oeuvre dans le dispositif selon la présente invention, en référence aux figures 7 à 12, et décrire des exemples de structures susceptibles d'être mises en oeuvre dans le détecteur selon la présente invention. Nous allons expliquer la théorie du fonctionnement du dispositif selon la présente invention, et en référence aux figures 13 à 15, donner des exemples d'application du dispositif selon la présente invention.

Sur la figure 1, l'on peut voir un détecteur de type connu comportant une première électrode 2 en niobium épitaxiée sur un support 1 en saphir formant une fenêtre d'entrée transparente aux rayons X. Une barrière 3 constituée par une couche d'aluminium, une couche d'oxyde d'aluminium (Al $O_x$) et une couche d'aluminium est interposée entre la première électrode 2 et une deuxième électrode 4 réalisée en niobium polycristallin. Une première électrode de connexion 5 en niobium est reliée à la deuxième électrode 4, tout en étant isolée de la première électrode 2 par une couche isolante 6 en Al $O_x$. Une seconde électrode de connexion 47, en niobium, est reliée à la première électrode 2.

Une jonction supraconductrice à effet tunnel (Superconducting Tunnel Junction ou STJ en terminologie anglo-saxonne) est établie à travers la barrière 3 entre la première électrode 2 et la deuxième électrode 4 sur la majeure partie de la surface du détecteur.

Sur les figures 2 à 6 et 29, l'on peut voir, schématisées, quelques interactions intervenant dans un détecteur selon la présente invention. Sur la partie gauche des figures 2 à 6 et 29, l'on a illustré les éléments interagissant et dans la partie droite, l'on a illustré le résultat de l'interaction.

La théorie microscopique quantique BCS, due à Bardeen, Cooper et Schrieffer, décrit comment les électrons 7, qui sont des Fermions (spin 1/2), minimisent leur énergie en s'associant deux à deux pour former des paires de Cooper 8 qui sont des bosons (spin entier). Cet état ordonné résulte de l'existence, dans un supraconducteur, d'une attraction entre électrons, par l'intermédiaire des vibrations du réseau atomique. Cette attraction est supérieure aux forces de répulsion électrostatiques entre deux électrons de même charge.

Sur la figure 2, l'on peut voir l'interaction entre un photon 9 et une paire de Cooper 8. Le photon peut également interagir avec les électrons des atomes du réseau et créer des électrons libres qui peuvent également briser des paires de Cooper et engendrer des phonons. Lorsque l'énergie du photon 9 est supérieure à la largeur de la bande interdite 2 $\Delta$ du spectre d'excitation du supraconducteur, il existe une probabilité d'interaction entre le photon 9 et une paire de Cooper dont résulte la génération de deux quasi particules 7' correspondant aux électrons ainsi que des phonons 10 formant les quantum d'énergie du champ de vibration mécanique dus à l'agitation des atomes dans le réseau supraconducteur.

Aux très basses températures, par exemple inférieures à 0,1 $T_c$ ($T_c$ étant la température critique du supraconducteur), la probabilité de rencontrer un phonon 10 d'énergie égale ou supérieure à 2 $\Delta$ est quasiment nulle. Ainsi, l'on peut dire que tous les phonons ayant une énergie supérieure ou égale à 2 $\Delta$ proviennent de l'interaction entre le photon 9 et une paire de Cooper 8 (correspond donc à la détection de l'arrivée d'un photon).

Les phonons dont l'énergie est inférieure à 2 $\Delta$, provenant directement de l'interaction entre les photons 9 et la paire de Cooper 8 ou obtenus par relaxation, ne participent pas à la détection de photons individuels, objets de la présente invention. Par contre, comme l'on peut le voir sur la figure 3, un phonon 10 d'énergie supérieure ou égale à 2 $\Delta$ peut briser une paire de Cooper 8 pour générer deux électrons 7' ainsi que d'autres phonons 10 de plus basse énergie. L'on assiste ainsi à une génération et à une propagation des quasi particules 7' qui, d'une part, augmentent le rendement quantique du détecteur selon l'invention (probabilité de détecter un photon 9 qui a interagi avec une paire de Cooper) ; d'autre part, l'on peut déduire l'énergie du photon incident 9 à partir du nombre de quasi particules 7' qui ont traversé par effet du tunnel la ou les jonction(s) supraconductrice(s).

Sur la figure 4, l'on peut voir l'interaction entre un photon 9 et la matière 11, par exemple avec le réseau supraconducteur ou avec une couche absorbante déposée à sa surface, notamment une couche de cuivre. L'absorption du photon 9 par la matière 11 conduit à l'apparition de phonons 10 qui vont pouvoir briser les paires de Cooper 8 selon les schémas illustrés sur la figure 3.

Comme l'on peut le voir sur la figure 5, la relaxation d'un phonon 10 de plus haute énergie peut déboucher sur la génération de phonons 10 de plus basse énergie. Il est à noter que les phonons 10, dont l'énergie est inférieure à la largeur 2 $\Delta$ de la bande interdite du spectre d'excitation du réseau supraconducteur, ne peuvent pas briser les paires de Cooper 8.

Sur la figure 6, l'on peut voir le passage d'une quasi particule 7' entre un premier supraconducteur 12, par exemple du niobium, ayant une première largeur de bande interdite 2 $\Delta_1$, vers un second matériau supraconducteur 13, par exemple de l'aluminium ayant une seconde largeur 2 $\Delta_2$ de la bande interdite du spectre d'excitation, inférieure à 2 $\Delta_1$. Le passage de la quasi particule 7' entre les milieux 12 et les milieux 13 génère un phonon 10 qui, par le mécanisme illustré sur la figure 3, va générer d'autres quasi particules 7' en brisant d'autres paires de Cooper 8. Par exemple, le passage du niobium, dont $\Delta$ est égal à 1,5 meV (1 eV est égal à 1,602 $10^{-19}$ J), vers l'aluminium, dont $\Delta$ est égal à 0,3 meV, correspond à la multiplication du nombre des quasi particules 7' par un facteur égal à 4,5.

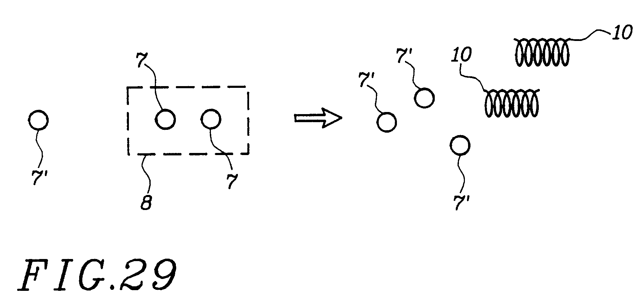

Sur la figure 29, l'on peut voir l'interaction entre une paire de Cooper 8 et une quasi particule 7' dont l'énergie est supérieure à l'énergie de liaison de la paire de Cooper. Il en résulte trois quasi particules 7' de plus basse énergie et de phonons 10. Ce phénomène permettant d'amplifier le nombre de quasi particules 7' caractéristiques de l'absorption d'un photon 9 à détecter est plus important dans les matériaux supraconducteurs ayant une faible largeur de la bande interdite, comme par exemple l'aluminium, que dans les matériaux supraconducteurs ayant une bande interdite de grande largeur comme le niobium.

Sur les figures 7 à 11, l'on peut voir divers exemples de réalisation de structure de cellules ou de détecteurs selon la présente invention.

Sur la figure 7, l'on peut voir un élément sensible supraconducteur 14 dans lequel des cellules spatiales ont été définies par des jonctions supraconductrices à effet tunnel 15 comprenant une barrière isolante de faible épaisseur 16 et une électrode supraconductrice 17. Dans cet exemple de réalisation, l'élément sensible 14 a une épaisseur et une rigidité suffisantes pour constituer la structure mécanique de cellules et/ou du détecteur ou repose sur un substrat situé sur la face arrière du détecteur (non représenté). L'élément sensible peut former un support soit au-dessus, soit en-dessous des jonctions.

Au contraire, dans l'exemple illustré sur la figure 8 l'élément sensible 14 a été déposé sur un substrat 18 rigide transparent au rayonnement de la bande de fréquence dans laquelle l'on veut pouvoir détecter les photons. Le substrat 18 doit être compatible avec les matériaux de l'élément 14 y compris aux très basses températures nécessaires à l'établissement de la supraconductivité.

Dans le cas de l'élément sensible en niobium, l'on peut, par exemple, utiliser du saphir pour la détection des photons visibles. L'on peut mettre en oeuvre un support 18 en saphir tandis que pour une détection devant s'étendre dans l'ultra-violet, l'on met en oeuvre du Mg $F_2$.

Sur la figure 9, qui se réfère à un grand espacement des jonctions, l'on peut voir un détecteur selon la présente invention comportant des parois 19 matérialisant la limite entre les cellules de détection et formant des canaux canalisant les quasi particules 7' vers les jonctions supraconductrices à effet tunnel 15. Pour favoriser la multiplication des quasi particules 7' et empêcher leurs migrations vers l'élément sensible 14, comme illustré sur la figure 6, les parois 19 sont réalisées dans un matériau supraconducteur dont la largeur de la bande interdite du spectre d'excitation est plus faible que la largeur de la bande interdite de l'élément supraconducteur sensible 14.

Dans le cas où l'élément sensible 14 est réalisé en niobium, les parois 19 sont avantageusement réalisées en aluminium.

Sur la figure 10, l'on peut voir l'exemple préféré de réalisation du dispositif selon la présente invention comportant une structure de la figure 9 qui a été déposée sur un substrat 18.

Sur la figure 11, l'on peut voir une structure comportant, entre le substrat 18 et l'élément sensible 14, une couche absorbante réalisée, par exemple, en cuivre. La couche de cuivre assure la thermalisation de photons 9, c'est-à-dire leur absorption et leur conversion en phonons 10 selon le principe illustré sur la figure 4.

Le dispositif de la figure 11 présente une résolution temporelle très élevée.

La cellule de détection et le détecteur selon la présente invention ont une efficacité quantique proche de 1 lorsqu'un photon est absorbé par l'élément sensible 14 ou par la couche absorbante 20. Lorsqu'un photon est absorbé par une paroi 19, l'efficacité quantique est toujours proche de 1, mais l'on aura une quantité plus élevée de quasi particules, et la réponse est limitée à une seule jonction.

Sur la figure 12, l'on peut voir, en perspective, l'exemple préféré de réalisation d'un détecteur selon la présente invention comportant une matrice de cellules carrées 21. Il est bien entendu que d'autres formes de cellules 21, comme par exemple des cellules triangulaires, hexagonales ou circulaires, ne sortent pas du cadre de la présente invention. De même, sans sortir du cadre de la présente invention, il est possible de réaliser un détecteur ne comportant qu'une unique cellule comprenant une ou plusieurs jonction(s) supraconductrice(s) à effet tunnel.

Dans l'exemple de réalisation de la figure 12, chaque cellule 21 est délimitée par quatre jonctions supraconductrices à effet tunnel 15 et par quatre parois 19 aboutissant aux jonctions 15 et disposées en carré. Avantageusement, un intervalle 22 équidistant de deux jonctions 15 adjacentes est ménagé dans chaque paroi 19. Ainsi, une quasi particule pénétrant dans une paroi 19 est canalisée vers la jonction supraconductrice à effet tunnel la plus proche. La présence des parois 19 en aluminium permet, d'autre part, d'améliorer la résolution temporelle en limitant le temps compris entre l'absorption du photon et la détection du signal par un confinement des quasi particules, et donc une limitation du trajet de propagation des quasi particules.

La jonction 15 supraconductrice à effet tunnel est mitoyenne entre quatre cellules 21, alors qu'une paroi 19 est mitoyenne entre deux cellules 21.

Chaque jonction supraconductrice à effet tunnel 15 est connectée à un amplificateur à faible bruit pour amplifier le courant des quasi particules 7' passant par effet tunnel.

Dans une variante de réalisation, les amplificateurs sont directement diffusés dans une tranche de semi-conducteurs avec le même pas que les jonctions supraconductrices à effet tunnel 15, la tranche de semi-conducteurs étant mise en contact avec les jonctions supraconductrices à effet tunnel 15 de la structure de la figure 12.

Sur la figure 13, l'on peut voir un exemple de réalisation d'un capteur selon la préseote invention comportant quatre cellules de détection 2111, 2112, 2121 et 2122. La cellule 2111 est délimitée par des jonctions supraconductrices à effet tunnel 1511, 1512, 1521 et 1522. La cellule de détection 2112 est délimitée par les jonctions supraconductrices à effet tunnel 1512, 1513, 1522 et 1523. La cellule de détection 2121 est délimitée par les jonctions supraconductrices à effet tunnel 1521, 1522, 1531 et 1532. La cellule de détection 2122 est délimitée par les jonctions supraconductrices à effet tunnel 1522, 1523, 1532 et 1533.

A chaque jonction supraconductrice à effet tunnel sont connectés, en série, un amplificateur à faible bruit 23, un convertisseur analogique numérique 24 et des moyens 25 de codage et/ou de traitement de l'information.

Avantageusement, un comparateur à seuil 26 est interposé entre la sortie des convertisseurs analogiques numériques 24 et l'entrée des moyens 25 de codage et/ou de traitement de l'information. Les moyens 25 comportent, avantageusement, un dispositif 27 de codage assurant l'association, à chaque signal de détection d'une valeur i de l'intensité ou de l'énergie proportionnelle au nombre des quasi particules détectées, le temps de détection t et le numéro ou les coordonnées de la jonction supraconductrice à effet tunnel concernée. Les données codées sont transmises à une unité arithmétique et logique 28 pour le stockage dans une mémoire de masse 29 et/ou pour le traitement en ligne ou en différé, l'affichage des résultats sur un dispositif de visualisation 30, l'impression sur une imprimante 31 ou la transmission par une ligne de communication 32 à un dispositif non représenté.

Dans une première variante de réalisation non illustrée, un dispositif de codage 27 est associé à chaque jonction supraconductrice à effet tunnel. Dans un tel cas, il est avantageux de connecter l'ensemble des dispositifs de codage 27 à une unité arithmétique et logique 28 par l'intermédiaire d'un multiplexeur.

Dans une deuxième variante de réalisation illustrée sur la figure 13, les sorties des comparateurs à seuil 26 sont reliées par l'intermédiaire d'un multiplexeur 33 à un unique dispositif de codage 27.

Une horloge 34 de très grande précision assure la synchronisation de l'échantillonnage et de la conversion du multiplexage et du codage.

Une interaction entre une cellule de détection, par exemple avec la cellule de détection 2111, génère un certain nombre de quasi particules, typiquement plusieurs milliers, dont une partie importante atteint les quatre jonctions supraconductrices à effet tunnel 1511, 1512, 1521 et 1522. Les quasi particules passent par effet tunnel à travers ces jonctions pour fournir un signal qui est amplifié par les amplificateurs faible bruit 23 correspondants. A la sortie des amplificateurs 23 correspondant aux jonctions supraconductrices de la cellule 2111, l'on obtient un signal qui est une fonction univoque du nombre de quasi particules détectées. A la sortie des autres amplificateurs 23, l'on retrouve un signal provenant, d'une part, des quasi particules libres présentes dans le matériau, de très faible à très basses températures, et d'autre part, constituant le bruit électronique de l'amplificateur 23. Au cas où la distance entre les jonctions est réduite, l'on pourrait faire la détection directement au niveau de ces jonctions.

Les signaux délivrés par les amplificateurs 23 sont échantillonnés et numérisés. Les comparateurs à seuil 26 éliminent les signaux trop faibles correspondant uniquement au bruit électronique des amplificateurs 23 et à la détection de paires de Cooper brisées, indépendamment de l'absorption d'un photon. Seuls les signaux correspondant aux jonctions supraconductrices à effet tunnel 1511, 1512, 1521 et 1522 sont transmis par l'intermédiaire du multiplexeur 33 au dispositif de codage 27. Le dispositif de codage 27 génère quatre données, chacune comportant une identification de la jonction supraconductrice, le temps de détection et l'intensité du courant détecté. L'unité arithmétique et logique 28 détermine, à partir des coordonnées des jonctions supraconductrices à effet tunnel ayant transmis un signal, quelle(s) est(sont) la ou les cellule(s) de détection qui a(ont) interagi avec un photon incident. Elle effectue la sommation des intensités du signal reçu correspondant à la détection d'un même photon, par exemple l'on additionne les intensités des signaux transmises à un temps $t_0$ par les jonctions supraconductrices à effet tunnel 1511, 1512, 1521 et 1522. L'unité arithmétique et logique en déduit les coordonnées spatiales de l'interaction entre les photons et le détecteur, le temps de l'interaction et l'énergie (et donc la longueur d'onde) du photon incident. Les résultats sont transmis, affichés et/ou stockés. Avantageusement, l'unité arithmétique et logique 28 effectue un traitement statistique permettant de présenter les données recueilles dans un intervalle de temps donné.

Dans une variante de réalisation à très haute résolution spatiale, l'unité arithmétique et logique 28 tient compte de l'intensité du courant à chaque jonction supraconductrice à effet tunnel pour déterminer par interpolation les coordonnées du point d'incidence à l'intérieur de la cellule ayant détecté le photon.

La détection simultanée de plusieurs photons est extrêmement rare, dans le cas d'un dispositif ayant une très bonne résolution temporelle et pour des sources de lumière faibles, notamment lors du traitement de rayonnements visibles ou ultraviolets provenant de corps célestes de faible magnitude. Dans le cas où cette détection est opérée par deux cellules non adjacentes, c'est-à-dire des cellules ne comportant pas de jonctions supraconductrices à effet tunnel communes, le traitement normal n'est pas perturbé.

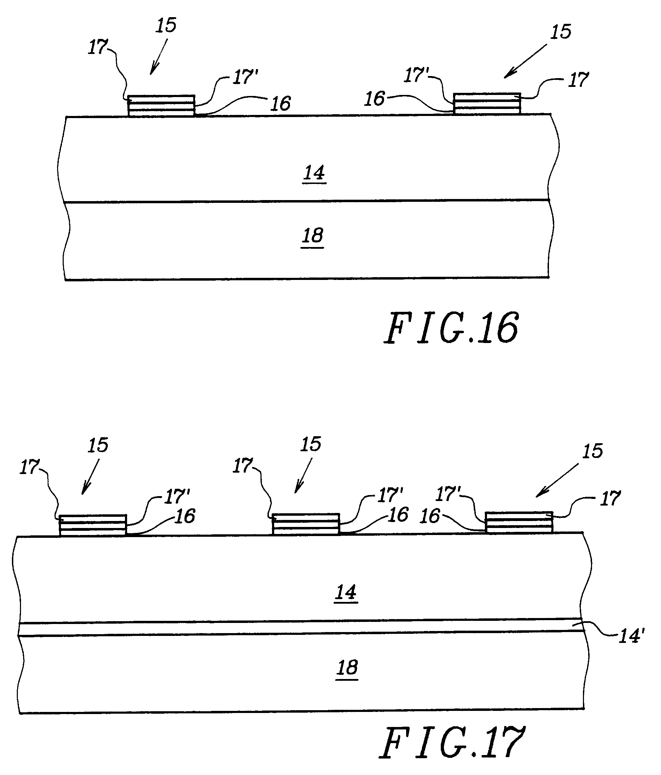

Il est bien entendu que l'invention n'est nullement limitée à l'utilisation du niobium pour les éléments sensibles 14 et de l'aluminium pour les parois 19. L'on peut, par exemple, comme illustré sur la figure 16 mettre en oeuvre pour les éléments sensibles 14 un matériau supraconducteur dont la largeur de la bande interdite 2 Δ du spectre d'excitation est faible, comme par exemple de l'aluminium. L'on forme, par exemple, une jonction supraconductrice à effet tunnel 15 avec l'élément sensible 14 en aluminium et une électrode 17' en aluminium entre lesquels est interposée une barrière isolante de faible épaisseur 16. Il peut s'avérer avantageux de recouvrir la couche d'aluminium 17' avec une couche d'accrochage 17 réalisée dans un métal facilitant les connexions, comme par exemple du niobium.

De même, comme illustré sur la figure 17, l'on peut interposer une couche 14' d'accrochage d'électrode entre le support 18 et les éléments sensibles 14. Dans l'exemple illustré sur la figure 17, les jonctions supraconductrices à effet tunnel 15 sont plus rapprochées, permettant d'augmenter la résolution temporelle en diminuant le trajet maximal des quasi particules vers la jonction la plus proche. Il est bien entendu que cette disposition peut, sans sortir du cadre de la présente invention, être reprise avec les exemples de réalisation illustrés sur les figures 7 à 12. Il est bien entendu que la présente invention n'est nullement limitée à la mise en oeuvre d'aluminium et de niobium, par exemple la mise en oeuvre de l'élément sensible en Sn permet d'obtenir plus de 3000 quasi particules pour l'absorption d'un photon de 3 eV avec une résolution spectrale sensiblement égale à 8 nm. Nous allons donner ci-après quelques éléments permettant de calculer les performances de la cellule de détection ou du détecteur selon la présente invention, en fonction des matériaux supraconducteurs mis en oeuvre.

Dans les supraconducteurs, la présence de paires de Cooper 8 représente l'état fondamental, alors que la présence des quasi particules 7' correspondant à l'état excité. Le nombre de quasi particules 7' à une température T (température absolue) exprimée en K est proportionnel à $\exp(-\Delta/KT)$, K étant la constante de Boltzmann. A faible température, le nombre de quasi particules 7' est extrêmement faible par rapport au nombre de quasi particules générées lors de l'interaction d'une cellule avec un photon. Comme indiqué sur les figures 2, 3 et 5, la population des quasi particules 7' dépend de la population et de l'énergie des phonons 10. Dans la mesure où la bande interdite du spectre d'excitation 2 Δ est inférieure à h $\omega_D$, h $\omega_D$ étant l'énergie de Debye. Les phonons 10 peuvent dans un système en relaxation (et non pas en équilibre) avoir une énergie suffisante pour participer au passage entre une paire de Cooper 8 et deux quasi particules 7'. La population des phonons 10 dont l'énergie h $\omega$ est supérieure à la bande interdite est couplée à la population des quasi particules. Les phonons de haute énergie sont produits durant l'absorption d'un photon (figure 2) et durant la relaxation de quasi particules 7' de haute énergie. Les phonons, dont l'énergie est inférieure à la bande interdite, sont notamment produits lors de la recombinaison de deux quasi particules 7' en une paire de Cooper.

Soit $\tau_c$, le temps de confinement des quasi particules dans un film supraconducteur.

$\tau_c$ est donné par :

$$\tau_c = e^2 \, N_{Ef} R_{nn} V \qquad (1)$$

où e est la charge de l'électron,

$N_{Ef}$ est la densité des états à l'énergie de Fermi,

$R_{nn}$ est la résistance électrique normale de la barrière isolante de la jonction supraconductrice à effet tunnel qui donne une indication sur la probabilité du passage des quasi particules par effet tunnel, et

V est le volume du film supraconducteur.

$1/\tau_c$ donne la fréquence de passages par effet tunnel des quasi particules.

Dans la mesure où $R_{nn}$ est proportionnel à exp(2b/A), b étant l'épaisseur de la barrière isolante et A étant la surface de la jonction supraconductrice à effet tunnel, $\tau_c$ dépend principalement du supraconducteur mis en oeuvre, de son épaisseur et de l'épaisseur de l'isolant mais est indépendant de la température T.

Soit $T_c$, la température critique du supraconducteur et $T_0$ une température inférieure au dixième de $T_c$. Le nombre de quasi particules à la température $T_0$ est proportionnel à exp(-Δ(0)/kT$_0$), Δ(0) étant la moitié de la bande interdite à la température de zéro absolu. L'absorption d'un photon conduit à une augmentation de la population des quasi particules 7' qui peut être associée à une population équivalente à une population N(T*) à une température T* correspondant à la température effective des quasi particules. La relaxation dépend donc de T* qui change avec l'évolution de la population. Le temps de recombinaison à faible température est donné par la formule de :

$$\tau_r(T^*) \simeq \tau_0 \left[ \pi^{1/2}\left(\frac{2\Delta(0)}{kT_c}\right)^{5/2}\left(\frac{T^*}{T_c}\right)^{1/2} \exp - \left(\frac{\Delta(0)}{kT^*}\right) \right]^{-1} \qquad (2)$$

où $\tau_0$ est le temps de confinement à la température de zéro absolu. Dans la mesure où $\tau_r$ est une fonction de la densité des quasi particules, la relation entre l'énergie du photon absorbé et le nombre des quasi particules n'est pas linéaire.

Le temps de passage d'une paire de Cooper 8 en deux quasi particules 7' (figure 3), en tenant compte des recombinaisons possibles, est donné par la formule :

$$\tau_b(T^*) = \tau_{ph} \frac{\Delta(0)}{\Delta(T^*)} \frac{1}{(1 - 2f(\Delta(T^*)))} \qquad (3)$$

où f(Δ(T)) est la fonction de Fermi et le $\tau_{ph}$ est une constante. La diminution de la probabilité d'interaction avec la température est due au fait qu'aux températures plus élevées, il y a moins de paires de Cooper susceptibles d'être brisées.

Il est à noter que les phonons sont perdus en sortant des cellules supraconductrices. Ces pertes dépendent de la géométrie de la cellule de détection, des épaisseurs des films mis en jeu, de la taille des électrodes de connexion et des couplages acoustiques entre les divers éléments de la cellule de détection.

D'une manière générale, la relaxation d'un supraconducteur avec couplage des phonons et de la population des quasi particules est décrite dans S.B. Kaplan, C.C. Chi, D.N. Langenberg, J.J. Chang, S. Jafarey et D.J. Scalapino, Phys. Rev. B 14 (1976) 4854 et J.-J. Chang et D.J. Scalapino, Phys. Rev. B 15 (1977) 2651 et peut être décrite dans le système de deux équations couplées :

$$\frac{dN_{qp}}{dt} = -\frac{N_{qp}}{\tau_c} - \frac{N_{qp}}{\tau_r(T^*)} + \frac{2N_{ph}}{\tau_b(T^*)} - \frac{N_{qp}}{\tau_d} \qquad (4)$$

$$\frac{dN_{ph}}{dt} = -\frac{N_{ph}}{\tau_b(T^*)} + \frac{N_{qp}}{2\tau_r(T^*)} - \frac{N_{ph}}{\tau_l}$$

où $N_{qp}$ est la densité des quasi particules,
$N_{ph}$ est la densité des phonons,
$\tau_c$ est le temps de confinement des quasi particules,
$\tau_r$ est le temps de recombinaison,
$\tau_d$ est le temps de diffusion,
$\tau_l$ est un temps caractéristique de la perte de phonons,
$\tau_b$ est un temps caractéristique de la cassure d'une paire de Cooper.

Le courant I par effet tunnel est donné par la formule :

$$I = \frac{N_{\mathrm{qp}}(T^*)(eV_b + \Delta)}{2N_{E_f}eR_{nn}((eV_b + \Delta)^2 - \Delta^2)^{1/2}} \qquad (5)$$

où $V_b$ est la tension de polarisation,

$0 < eV_b < 2\Delta$.

Suite à l'absorption d'un photon, le nombre moyen $N_0$ de l'excès de porteurs de charges créés dans le supraconducteur est donné par :

$$N_0 = E/\varepsilon \qquad (6)$$

où $E = h\nu$ est l'énergie du photon incident et $\varepsilon$ l'énergie moyenne nécessaire pour créer un porteur de charges. La résolution spectrale du détecteur, définie comme la largeur de la distribution de l'énergie captée provenant d'un rayonnement monochromatique à mi-hauteur par rapport à l'énergie maximale, est donnée par :

$$\Delta E = 2.35\sqrt{FE\varepsilon} \qquad (7)$$

où F est le facteur de Fano défini par :

$$\mathrm{Var}(N_0) = FN_0. \qquad (7')$$

Une solution approchée de l'équation 4 est donnée par :

$$\frac{N}{N_0} = \frac{\tau_c^{-1}}{\tau_c^{-1} + \langle\tau_r^{-1}\rangle + \tau_d^{-1}} \qquad (8)$$

où $\langle\tau^{-1}\rangle$ est une valeur moyenne dans le temps du temps de recombinaison réelle des paires de Cooper à partir des quasi particules 7'.

Exemple de réalisation : éléments photosensibles en niobium ayant une surface comprise entre 150 et 400 $\mu m^2$, une épaisseur comprise entre 50 et 300 nm, $\tau_c$ compris entre 60 et 5000 ns ($\tau_c$ égal à 60 ns pour la plus faible valeur de la résistance $R_{nn}$ égale à 0,6 $\Omega$) et le volume étant égal à 20 $\mu m^3$. Il est probable que $\tau_c$ pourra être réduit à 10 ns par une réduction de la taille de la jonction. $\tau_c$ peut encore être réduit d'un facteur 2,5 qui correspond au rapport de valeur de $N_{Ef}$ de Nb par rapport à Al. Dans du niobium massif à une température inférieure à 2 Kelvin, $\varepsilon$ peut être estimé à 1,747 $\Delta$ et F à 0,22. Von en tire que l'on peut espérer générer 1100 quasi particules 7' pour un photon d'énergie égal à 3 eV. Il est à noter qu'il n'est pas du tout avantageux d'augmenter la surface ou l'épaisseur de l'élément sensible 14. Bien que cette augmentation conduise à une sensibilité plus élevée (probabilité d'interaction entre la matière et le rayonnement incident plus élevée), elle augmente la capacité, ce qui dégrade la résolution spectrale tandis qu'une augmentation de l'épaisseur diminue l'intensité du courant pour un nombre de quasi particules donné. Dans la mesure où, pour des photons visibles ou des ultraviolets, la densité de charges générée dans le supraconducteur est faible et donc n'augmente que faiblement la probabilité de recombinaison des quasi particules 7' en paire de Cooper, il semble particulièrement avantageux de recourir à des détecteurs matriciels comportant des cellules de détection de faible surface. La Demanderesse envisage la réalisation de cellules de 3 $\mu m$ sur 3 $\mu m$ et de 0,01 $\mu m$ d'épaisseur.

Le rapport signal/bruit peut être amélioré en éliminant les signaux dont l'évolution temporelle ne correspond pas à un signal provenant de l'absorption d'un photon.

Pour une telle épaisseur, il peut s'avérer avantageux d'utiliser une couche absorbante convertissant l'énergie d'un photon incident en phonons de haute énergie (figures 4 et 11).

La résolution énergétique peut être estimée à 0,1 eV correspondant à une résolution spectrale de 13 nm à 400 nm, dans le cas du niobium.

La résolution spatiale dépend de la taille des cellules de détection dans le cas de présence des parois 19 et de la diffusion des quasi particules pendant le temps $\tau$ en cas d'absence de ces parois. La diffusion des quasi particules à un temps t est une fonction du trajet libre moyen $\lambda_{qp}$ et de la vitesse de Fermi $v_F$. Pour du niobium, l'on peut estimer que pour $\tau$ égal à 1 $\mu$s, l'on peut avoir une diffusion sur 1 mm. Pour un film mince, la diffusion des quasi particules doit obéir à l'équation de diffusion bidimensionnelle donnée par la formule :

$$\frac{\partial^2 u}{\partial x^2} + \frac{\partial^2 u}{\partial y^2} = \frac{1}{k}\frac{\partial u}{\partial t} \tag{9}$$

qui doit satisfaire les conditions limites :

$$u(0,y,t) = u(l,y,t) = u(x,0,t) = u(x,l,t) = 0 \qquad t \geq 0$$

$$u(x,y,0) = N\delta(x - x_0, y - y_0) \qquad 0 \leq x_0 \leq l, 0 \leq y_0 \leq l \tag{10}$$

La solution peut être écrite sous la forme :

$$u(x,y,t) = N\sum_{r=1}^{\infty}\frac{2}{l}\sin\left(\frac{r\pi x_0}{l}\right)\sin\left(\frac{r\pi x}{l}\right)\exp-\left(\frac{r^2\pi^2 kt}{l^2}\right)\times\sum_{s=1}^{\infty}\frac{2}{l}\sin\left(\frac{s\pi y_0}{l}\right)\sin\left(\frac{s\pi y}{l}\right)\exp-\left(\frac{s^2\pi^2 kt}{l^2}\right) \tag{11}$$

et le courant des quasi particules à travers la limite pour $x = x_b$ est donné par :

$$\int_{y_1}^{y_2}\int_0^{\infty}\frac{\partial u}{\partial x}|_{x=x_b}\,dt\,dy = \frac{4N}{\pi^2 k}\sum_{r=1}^{\infty}\sum_{s=1}^{\infty}\frac{r}{s}\frac{1}{r^2+s^2}\cos\left(\frac{r\pi x_b}{l}\right)\sin\left(\frac{r\pi x_0}{l}\right)\times\sin\left(\frac{s\pi y_0}{l}\right)\left[-\cos\left(\frac{s\pi y}{l}\right)\right]_{y_1}^{y_2} \tag{12}$$

L'on peut déterminer de même le flux de particules à la limite $y = y_b$.

L'on peut déterminer, à partir de l'équation 12, les valeurs des flux de particules à travers les limites données.

Cette distribution théorique a été comparée à un modèle de statistique de marche aléatoire, dite statistique de Monte-Carlo, qui montre une divergence de 2 % entre les deux modèles pour $N_0 = 1100$ conduisant à une résolution spatiale de 20 $\mu$m pour des jonctions supraconductrices à effet tunnel distantes de 1 mm. Ce calcul correspond à l'hypothèse que toutes les quasi particules 7' arrivant à une jonction supraconductrice à effet tunnel sont détectées. Celle hypothèse correspond sensiblement à la vérité dans la mesure où pour les températures mises en oeuvre, l'on obtient une très faible probabilité de recombinaison de paires de Cooper. De même, dans ce calcul de résolution spatiale, l'on a négligé le courant par effet tunnel inverse (du dispositif d'amplification vers les parois 19).

Dans le tableau 1, l'on peut voir tes caractéristiques pertinentes de quelques matériaux supraconducteurs à basse température susceptibles d'être mis en oeuvre dans une cellule de détection selon la présente invention.

| Matière | $T_c$ (K) | $\Delta(0)$ (meV) | $\tau_0$ (ns) | $\tau_{ph}$ (ns) | $v_F$ $(10^6\,\mathrm{m\,s^{-1}})$ | $N_{E_f}$ $(10^{21}\,\text{états}\,\mathrm{eV^{-1}\,cm^{-3}})$ |
|---|---|---|---|---|---|---|
| Nb | 9.3 | 1.525 | 0.149 | 0.004 | 1.37 | 31.7 |
| Pb | 7.2 | 1.37 | 0.196 | 0.034 | 1.83 | 8.6 |
| Ta | 4.5 | 0.7 | 1.78 | 0.023 | — | 40.8 |
| Sn | 3.7 | 0.57 | 2.30 | 0.110 | 1.90 | 8.1 |
| Al | 1.2 | 0.17 | 438 | 0.242 | 2.03 | 12.2 |

## TABLEAU I

Il est bien entendu que ce tableau n'a aucun caractère limitatif et que, notamment, il est possible, sans sortir du cadre de la présente invention, de mettre en oeuvre d'autres matériaux supraconducteurs et notamment des matériaux supraconducteurs dits "à haute température".

L'exemple préféré de réalisation du dispositif selon l'invention met en oeuvre trois matériaux pour, respectivement, l'élément sensible 14, les parois 19 et les jonctions supraconductrices à effet tunnel 15 ayant des largeurs de bande interdite 2 Δ de plus en plus réduites pour favoriser le transfert des quasi particules 7'.

Le dispositif selon la présente invention peut avantageusement être mis en oeuvre dans un spectroscope.

Dans un premier exemple de réalisation d'un spectroscope selon la présente invention, l'on met directement en oeuvre un capteur du type de celui illustré sur la figure 13 comportant avantageusement un important nombre de cellules 21.

La résolution spectrale du dispositif de la figure 13 provient directement de la résolution énergétique du détecteur selon la présente invention.

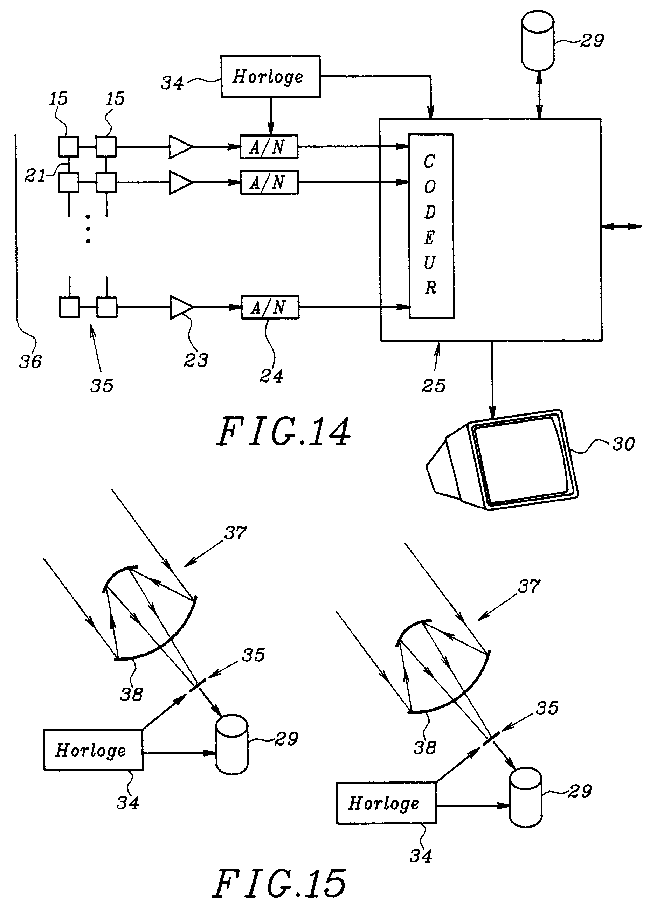

Sur la figure 14, l'on peut voir un second exemple de réalisation d'un spectroscope selon la présente invention comportant un détecteur 35, avantageusement linéaire, placé derrière un dispositif dispersant, par exemple un réseau de diffraction 36. La sortie des jonctions 15 est connectée de manière analogue à celle du dispositif de la figure 13, à une unité de stockage et/ou de traitement de l'information 25.

Le spectromètre de la figure 14 a une excellente résolution spectrale provenant d'une part de la présence du réseau de diffraction 36 et de la résolution spatiale du détecteur 35 et, d'autre part, de la résolution spectrale de ce détecteur.

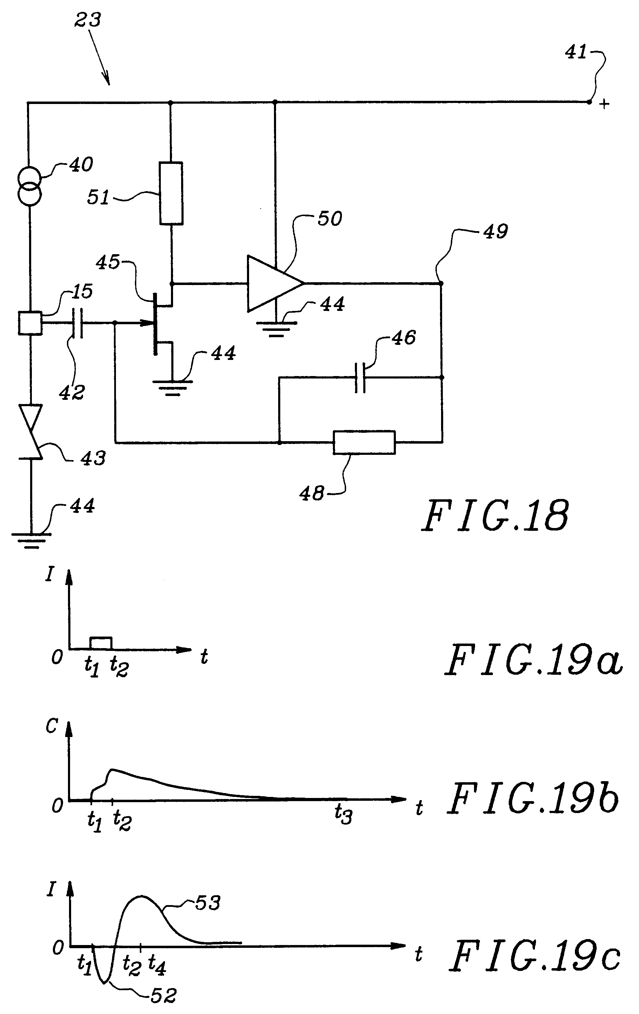

Les performances d'un détecteur selon la présente invention dépendant principalement des caractéristiques de la cellule de détection, mais peuvent également être dégradées par le bruit généré par l'amplificateur 23 notamment si la charge électrique (nombre de quasi particules 7') générée par photon 9 détecté est faible. L'on peut tout d'abord réduire le bruit de l'amplificateur par un refroidissement par exemple à la température de travail de jonctions supraconductrices. L'on peut également diminuer le bruit par un traitement du signal illustré sur les figures 18 à 24.

Sur la figure 18, l'on peut voir un premier amplificateur 23 utilisable notamment pour de très faibles intensités d'éclairement (temps important entre les interactions de la cellule avec les photons 9 successifs). La jonction supraconductrice à effet tunnel 15 est reliée à un générateur de courant 40, à la borne d'alimentation d'entrée 41, à une première armature d'un condensateur 42 et, par l'intermédiaire d'une diode Zener 43 à la masse 44. La seconde armature du condensateur 42 est reliée à la grille d'un transistor à effet de champ 45 à une première armature d'un condensateur 46 et à l'entrée d'une résistance 48. La seconde armature du condensateur 46 et la sortie de la résistance 48 sont reliées à la borne 49 à laquelle est disponible le signal de sortie amplifié. Une première électrode du transistor à effet de champ 45, par exemple le drain, est reliée à la masse 44. La seconde électrode du transistor 45, par exemple la source, est reliée, d'une part, à l'entrée d'un amplificateur 50 et, d'autre part, par l'intermédiaire d'une résistance 51 à la borne + 41. Les bornes d'alimentation de l'amplificateur 50 sont reliées à la masse 44 et à la borne + 41. La sortie de l'amplificateur 50 est reliée à la borne de sortie 49 de l'amplificateur 23. Dans un exemple de réalisation, la résistance 48 avait une valeur de 300 MΩ alors que le condensateur 46 avait une capacité d'un pF.

L'amplificateur 23 de la figure 18 peut être optimisé pour la mesure de l'énergie du photon 9 capté en utilisant une constante de temps plus longue de l'amplificateur. Au contraire, en adoptant une constante de temps courte pour l'amplificateur, on réduit les délais entre deux photons susceptibles d'être détectés. Dans le premier cas, pour que l'on puisse mesurer de façon fiable la charge de la cellule de détection correspondant de façon biunivoque à l'énergie du photon, deux photons successifs doivent être séparés par au moins une micro seconde. Dans le second cas, une constante de temps de l'amplificateur peut être de l'ordre du temps de relaxation de jonction supraconductrice à effet tunnel, ce qui ne permet pas une mesure précise de la charge totale induite par le photon dans la cellule de détection.

Le comportement de l'amplificateur 23 de la figure 18 susceptible de mesurer avec une bonne précision la charge induite dans la cellule de détection est illustré sur la figure 19.

Sur la figure 19a, l'on a illustré le courant I en fonction du temps t délivré par la jonction connectée à l'amplificateur 23. Le courant forme sensiblement un signal carré entre le temps $t_1$ et $t_2$.

Sur la figure 19b, l'on peut voir la charge C en fonction du temps t dans la cellule de détection. Le temps $t_1$ correspond à la capture d'un photon 9. Entre $t_1$ et $t_2$, l'on assiste à la relaxation de la jonction supraconductrice à effet tunnel 15 avec amplification du nombre de quasi particules 7'. Entre $t_2$ et $t_3$, l'on assiste à la décharge de la jonction 15 dans l'amplificateur 23 avec diminution exponentielle de la charge selon la formule $Ae^{-t/\tau c}$,

$\tau_c$ étant typiquement compris entre 10 et 300 µs.

Sur la figure 19c, l'on peut voir le signal I délivré par l'amplificateur 23 en fonction du temps t. Le signal étant nul jusqu'en $t_1$, il comporte une alternance négative 52 entre $t_1$ et $t_2$ suivie par une alternance positive 53. De la forme de celle alternance positive 53, l'on détermine par traitement du signal dans une unité arithmétique et logique 28 la charge totale délivrée par la jonction supraconductrice à effet tunnel 15.

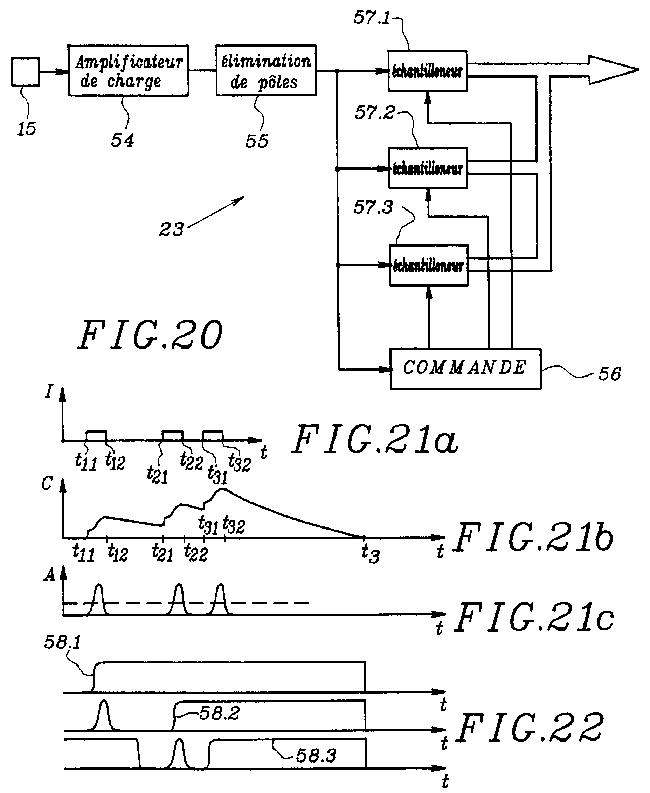

Sur la figure 20, l'on peut voir l'amplificateur 23 comportant des moyens de traitement assurant la séparation des signaux engendrés par une pluralité de photons 9 détectés à intervalles rapprochés. Ce dispositif est applicable aussi bien à des niveaux d'illumination moyens, par exemple pour observer des corps célestes de magnitude moyenne ou élevée. Le dispositif de la figure 20 comporte un amplificateur de charge 54 connectée à la sortie de la jonction supraconductrice à effet tunnel 15. La sortie de l'amplificateur 54 est connectée à l'entrée d'un dispositif d'élimination de pôles. La sortie du dispositif 55 d'élimination de pôles est connectée à l'entrée d'un dispositif de commande 56 et aux entrées analogiques d'une série d'échantillonneurs bloqueurs 57, par exemple aux entrées de trois échantillonneurs bloqueurs 57.1, 57.2 et 57.3. Le dispositif de commande 56 est relié par des lignes de commande aux divers échantillonneurs bloqueurs 57. Les sorties numériques des échantillonneurs bloqueurs 57 sont reliées, par exemple, par l'intermédiaire de l'unité arithmétique et logique 28 à l'unité de stockage 29.

Nous allons maintenant nous référer aux figures 21 et 22 pour expliquer le fonctionnement du dispositif de la figure 20.

Les figures 21a et 21b sont analogues respectivement aux figures 19a et 19b, mais illustrent la capture de trois photons aux temps $t_{11}$, $t_{21}$ et $t_{31}$.

Sur la figure 22b, la charge augmente tout d'abord entre $t_{11}$ et $t_{12}$ suite à la relaxation de la jonction 15 après la détection du premier photon puis décroît exponentiellement entre $t_{12}$ et $t_{21}$. Entre $t_{21}$ et $t_{22}$, la charge croît à partir du niveau résiduel de charges provenant de la capture du premier photon, lors de la relaxation de la jonction consécutive à la capture du deuxième photon. Entre $t_{22}$ et $t_{31}$, la charge totale décroît exponentiellement. Entre $t_{31}$ et $t_{32}$, la charge résiduelle s'accroît lors de la relaxation de la jonction 15 par suite de la capture du troisième photon. En $t_{32}$ et $t_3$, la charge décroît exponentiellement jusqu'à atteindre une valeur nulle.

Sur la figure 22c, l'on a représenté les pôles correspondant aux détections des divers photons.

Sur la figure 22d, l'on peut voir les signaux 58.1 à 58.3 générés par le dispositif de commande 56 et commandant respectivement les échantillonneurs 57.1 à 57.3. Lors de la capture du premier photon, la fonction 58.1 passe au niveau haut permettant à l'échantillonneur 57.1 d'assurer l'échantillonnage de la charge reçu, et ce par exemple jusqu'à l'instant $t_3$. La fonction 58.2 comportant une impulsion lors de la capture du premier photon passe à un niveau bas et passe à un niveau haut au moment de la capture du deuxième photon et ce, par exemple, jusqu'à $t_3$. La fonction 58.3 comporte une impulsion au moment de la capture du second photon et un passage au niveau haut lors de la capture du troisième photon. L'unité arithmétique et logique 28 reconstitue les charges correspondant aux divers photons en calculant d'abord à partir des informations disponibles entre $t_{12}$ et $t_{21}$ la charge générée par l'interaction avec le premier photon. Ensuite, en soustrayant cette charge de la charge mesurée en $t_{22}$ et $t_{31}$ l'unité arithmétique et logique 28 détermine la charge engendrée par l'interaction avec le deuxième photon. De même en soustrayant la charge du deuxième photon, l'unité arithmétique et logique détermine la charge générée lors de l'interaction avec le troisième photon.

Il est bien entendu qu'un amplificateur 23 comportant plus de trois échantillonneurs 57 ne sort pas du cadre de la présente invention.

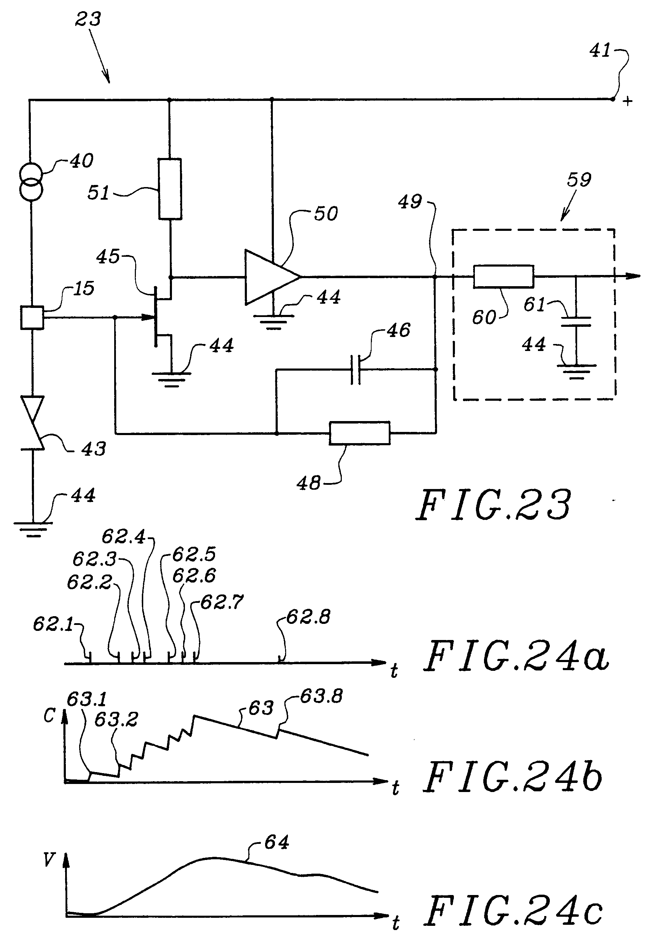

Il peut être intéressant, notamment pour des niveaux d'illumination importants, avec une forte probabilité d'interaction simultanée entre l'élément sensible 14 d'une même cellule de détection avec plusieurs photons 9, d'obtenir un signal dont la valeur, par exemple la tension, est une fonction de l'intensité lumineuse à mesurer. Un exemple d'un amplificateur 23 susceptible de délivrer un signal analogique indiquant l'intensité de l'illumination d'une cellule de détection est illustré sur la figure 23 qui est sensiblement identique à l'amplificateur 23 de la figure 18 complété à sa sortie 49 par un circuit intégrateur 59 comportant par exemple une résistance 60 placée en série avec un condensateur 61 disposé entre la sortie de la résistance 60 et la masse 44. Avantageusement, l'amplificateur 23 de la figure 23 peut être commuté selon les niveaux d'illumination instantanés, entre la mesure des énergies individuelles des photons incidents délivrés à la borne 49 et la valeur d'une illumination continue délivrée en sortie du circuit intégrateur 59.

Le fonctionnement de l'amplificateur 23 est expliqué sur les figures 24a à 24c.

Sur la figure 24, l'on a représenté en 62.1 à 62.8 les instants d'interaction entre des photons incidents et une cellule de détection selon la présente invention.

Sur la figure 24b, l'on peut voir la courbe 63 correspondant à la charge C générée par l'interaction entre les photons 62.1 à 62.8 avec la cellule de détection capturée par la jonction 15 connectée à l'amplificateur 23.

Sur la figure 24c, l'on peut voir une courbe 64 représentant un signal, par exemple une tension V, en fonction du temps dont la valeur indique l'éclairement reçu par la cellule de détection selon la présente invention.

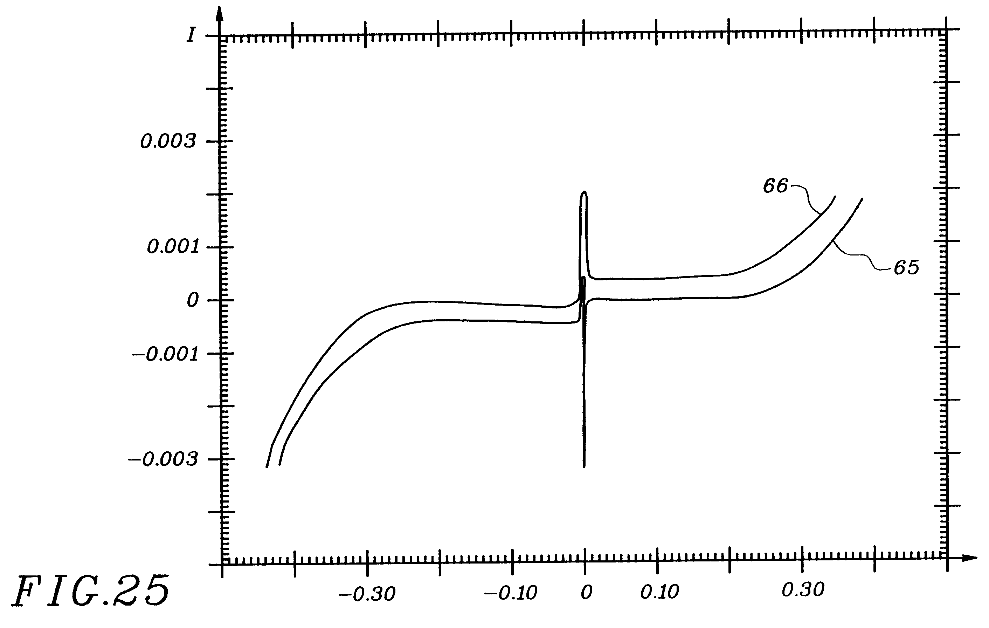

Sur les figures 25 à 28, l'on a illustré des performances obtenues avec un prototype de cellule de détection comprenant une unique jonction supraconductrice à effet tunnel carrée de 12 μm de côté en niobium travaillant à 0,3 K. La jonction supraconductrice à effet tunnel était connectée à un amplificateur 23 générant un bruit important, ce qui n'a pas permis dans cette expérimentation de mettre en évidence le comptage de photons individuels.

Sur la figure 25, l'on peut voir l'illumination I exprimée en μA en fonction de la tension de polarisation de la jonction supraconductrice à effet tunnel exprimée en mV. La courbe 65 correspond à l'intensité du courant en fonction de la tension de polarisation pour une cellule de détection non illuminée.

La courbe 66 correspond à l'intensité du courant en fonction de la tension pour une cellule illuminée par un rayonnement à 1 000 nm. En regardant la courbe 65, l'on s'aperçoit que le courant à travers la jonction supraconductrice à effet tunnel 15 est sensiblement négligeable pour une tension de polarisation inférieure à 0,3 mv. Cette tension sera donc avantageusement adoptée comme tension de polarisation de la jonction supraconductrice à effet tunnel. La différence d'intensité I entre les courbes 66 et 65 est extrêmement importante permettant la détection de l'illumination de la cellule.

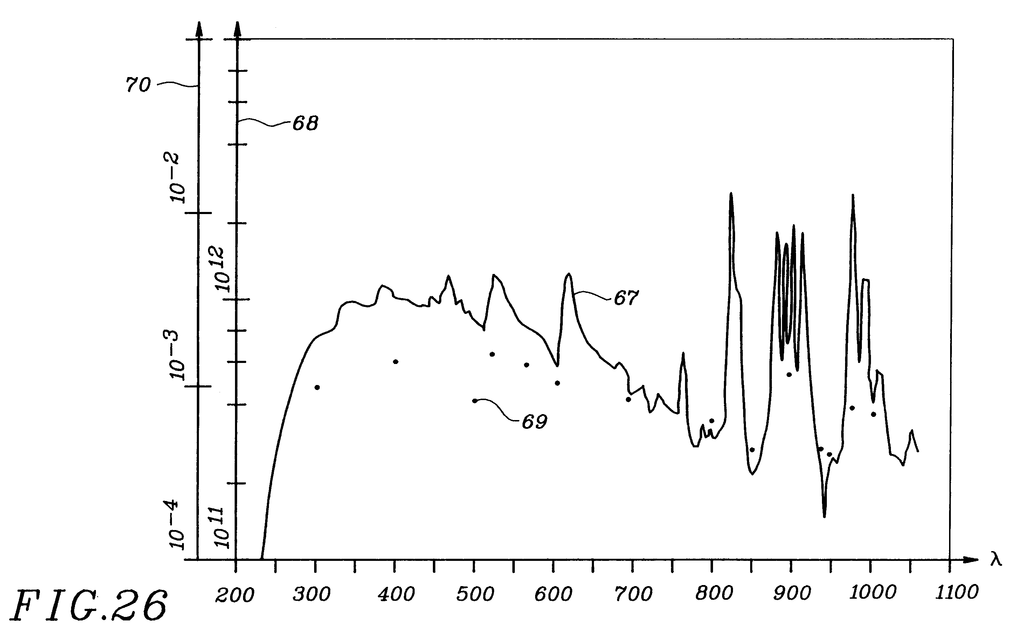

Sur la figure 26, l'on peut voir, d'une part, une courbe 67 indiquant la réponse en fréquence exprimée en photons par seconde sur l'échelle logarithmique 68 d'une source lumineuse en fonction de la longueur d'onde λ exprimée en nm et, d'autre part, le courant 69 exprimé en μA sur l'échelle logarithmique 70 d'une jonction supraconductrice à effet tunnel de la cellule de détection précitée normalisée pour une longueur d'onde de 250 nm. Pour un large spectre d'illumination, l'on obtient une bonne corrélation entre l'intensité lumineuse émise et l'intensité du courant électrique dans la jonction supraconductrice à effet tunnel.

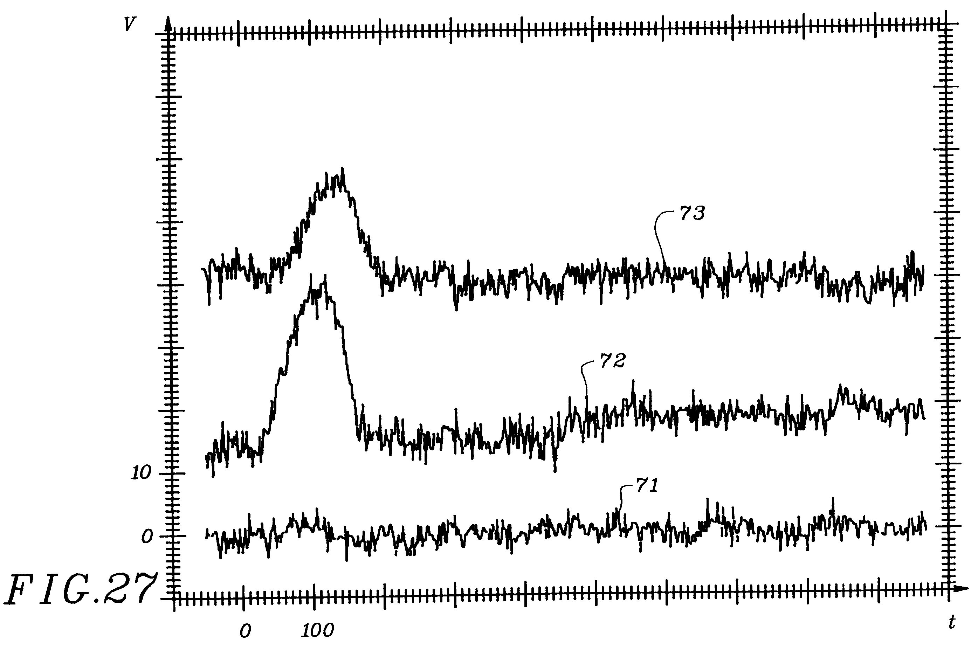

Sur la figure 27, l'on peut voir la tension de sortie d'un étage de pré-amplification de la jonction supraconductrice à effet tunnel de la cellule de détection selon la présente invention en fonction du temps t. Une division de l'échelle du temps t correspond à 100 μs (divisée en 10 sous-divisions de 10 μs). Les trois courbes 71, 72 et 73 sont décalées dans les sens des tensions V les unes par rapport aux autres. Une division de l'échelle des tensions V correspond à 10 mV (divisée en 10 sous-divisions d'1 mV). La courbe 71 correspond au bruit en l'absence d'illumination. La courbe 72 correspond à une impulsion de photons dont la longueur d'onde est sensiblement égale à 400 nm.

Les impulsions ont une durée d'une μs et correspondent à plusieurs centaines de photons. L'étalement dans le temps des impulsions de courbes 72 et 73 s'explique par le temps de réponse de la chaîne d'amplification connectée à la sortie de la jonction supraconductrice à effet tunnel, l'effet physique au niveau de la cellule de détection étant de l'ordre de la μs.

Les courbes 72 et 73 prouvent la possibilité de mise en oeuvre des cellules de détection selon la présente invention pour la détection de courtes impulsions de photons pour des bas niveaux d'illumination avec un large spectre.

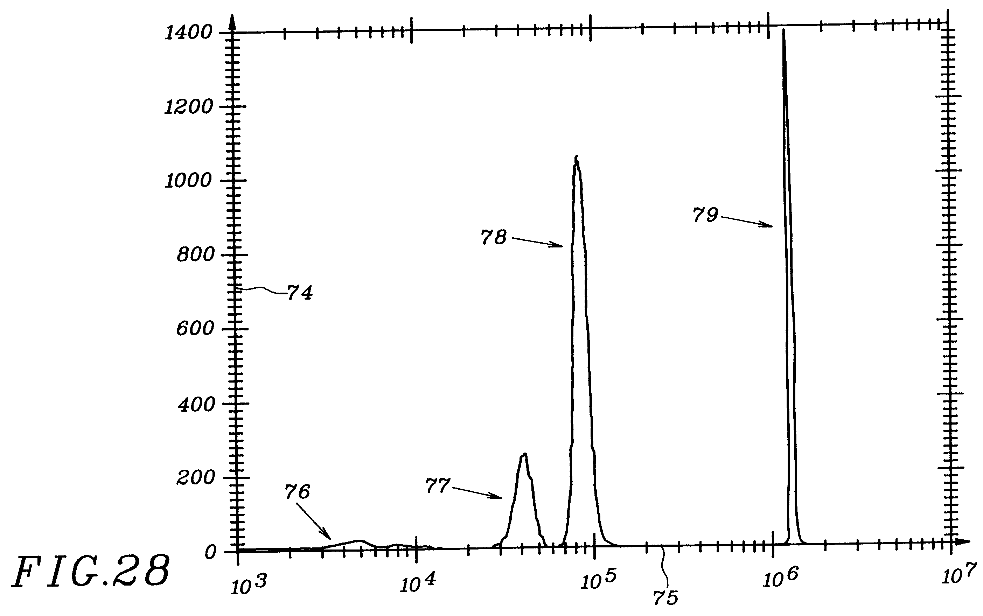

Sur la figure 28, l'on peut voir le nombre d'impulsion lumineuse en 74 en fonction de la charge 75 exprimée en nombre d'électrons recueillis aux bornes d'une jonction supraconductrice à effet tunnel 15 d'une cellule selon la présente invention. Les impulsions lumineuses ont une longueur d'onde de 820 nm et avaient une durée d'une μs. L'on a utilisé un amplificateur classique non refroidi dont le bruit porte la référence 76 sur la figure 28. En 77, l'on peut voir la distribution des impulsions de 70 photons. En 78, l'on peut voir la distribution des impulsions de 150 photons. En 79, l'on peut voir la distribution des impulsions de 2 250 photons. Le nombre de photons par impulsion a été estimé théoriquement, ainsi qu'à partir de la largeur de la distribution. De la largeur de distribution, l'on peut espérer détecter des impulsions de 20 photons avec l'amplificateur mis en oeuvre pour cette expérience. Pour effectuer un comptage des photons individuels, il serait nécessaire, soit d'augmenter le nombre de quasi particules par photon, par exemple en utilisant des jonctions à base d'aluminium et/ou utiliser un amplificateur 23 à faible bruit, par exemple un amplificateur refroidi à la température des jonctions supraconductrices à effet tunnel.

Sur la figure 15, l'on peut voir un exemple d'interféromètre selon la présente invention permettant, notamment grâce à l'excellente résolution temporelle des détecteurs selon la présente invention, de recueillir le rayonnement cohérent des corps célestes. Ce rayonnement cohérent correspond à un rayonnement non perturbé par les turbulences atmosphériques (speckle en terminologie anglo-saxonne). Le dispositif comporte deux sous-ensembles 37 identiques comprenant chacun un télescope 38 de faible diamètre à la sortie duquel est placé un capteur selon la présente invention, par exemple le capteur illustré sur la figure 13. Les horloges 34 des sous-ensembles 37 fonctionnent de manière synchrone pendant l'acquisition des données. Ce synchronisme est obtenu soit par une synchronisation des horloges 34 entre elles, ou par une horloge mère, soit par une extrême précision de ces horloges, mettant par exemple en oeuvre des horloges atomiques.

Les sous-ensembles 37 d'un interféromètre de la figure 15 sont placés à une distance pouvant varier entre une centaine de mètres et quelques centaines de kilomètres ou plus. Les télescopes 38 des sous-ensembles 37 sont pointés avec une très grande précision dans la même direction en site et en gisement. Lors du traitement des données recueillies par les sous-ensembles 37, l'on ne considère que l'information cohérente (interférence constructive) recueillie correspondant à l'information non perturbée par les turbulences atmosphériques.

De même, un capteur selon la présente invention peut être mis à la sortie d'un télescope classique pour permettre l'observation d'un astre de faible ou de très faible magnitude. La mise en oeuvre du dispositif selon la présente invention permet de recueillir des informations complémentaires par rapport au dispositif de type connu tout en réduisant le temps d'exposition, ce qui permet de réaliser plus d'observations avec un même télescope.

Le dispositif selon la présente invention s'applique au comptage de photons, et donc principalement à l'acquisition et au traitement de l'information provenant de sources de rayonnement faibles.

Bien que l'invention s'applique principalement à l'astronomie, elle peut également être mise en oeuvre pour des applications médicales (détection en lumière atténuée, tomographie, etc...), des acquisitions d'images dans l'atmosphère (détection cohérente, photographie, optiques adaptatives), des appareils de vision nocturne ou analogues.

**Revendications**

1. Cellule de détection de photons comportant un élément supraconducteur (14) en niobium sensible au photon (9) du rayonnement à détecter ou à des phonons (10) engendrés par un tel photon (9), par séparation de la paire de Cooper (8) en quasi-particules (7') et une jonction supraconductrice à effet tunnel (15) comprenant une électrode supraconductrice (17), l'élément supraconducteur photosensible ayant des caractéristiques à la température de travail, de largeur de bande interdite du spectre d'excitation ($2 \Delta$) et d'épaisseur permettant une baisse de l'énergie de chaque quasi particule (7') issue de la paire de Cooper (8) brisée avec multiplication du nombre de quasi-particules par un facteur compris entre 100 et 1000 dans le spectre allant du proche infrarouge à l'ultraviolet et la cellule étant délimitée par une pluralité de jonctions supraconductrices à effet tunnel (15) espacées, réparties à la périphérie de la cellule (21), caractérisée en ce que la cellule comporte à la périphérie, des parois (19) aboutissant aux jonctions supraconductrices à effet tunnel (15), en un matériau supraconducteur, ç-à-d. en Al, dont la largeur de la bande interdite du spectre d'excitation $2 \Delta_2$ est inférieure à la largeur $2 \Delta_1$ de la bande interdite du spectre d'excitation du matériau de l'élément sensible (14), de façon à ce que lesdites parois (19) forment des canaux pour canaliser les quasi particules (7') vers les jonctions supraconductrices à effet tunnel (15) et que le nombre de quasi particules (7') augmente après le passage d'une quasi particule (7') de l'élément sensible (14) dans une paroi (19).

2. Cellule selon la revendication 1, caractérisée en ce que les parois (19) comportent des discontinuités (22), de préférence à mi-distance entre deux jonctions supraconductrices à effet tunnel (15) adjacentes.

3. Cellule selon l'une quelconque des revendications précédentes, caractérisée en ce que l'élément sensible (14) a une faible épaisseur et est déposé sur un substrat (18) transparent au rayonnement électromagnétique à capter.

4. Cellule selon la revendication 3, caractérisée en ce qu'elle comporte une couche (20) de faible épaisseur absorbant le rayonnement à capter, ladite couche (20) étant disposée entre le support (18) et l'élément sensible (14).

5. Cellule selon l'une quelconque des revendications précédentes, caractérisée en ce que la jonction supraconductrice à effet tunnel (15) est en aluminium recouvert par une couche d'accrochage d'électrode en niobium (17, 14').

6. Détecteur, caractérisé en ce qu'il comporte une pluralité de cellules (21) selon l'une quelconque des revendications précédentes, notamment détecteur linéaire comportant des cellules (21) alignées selon un axe ou un détecteur matriciel comportant des cellules (21) alignées selon des lignes et des colonnes.

7. Capteur comportant une cellule selon l'une quelconque des revendications 1 à 5, ou un détecteur selon la revendication 6, caractérisé en ce qu'il comporte un amplificateur à faible bruit (23) connecté à chaque jonction supraconductrice à effet tunnel (15) pour amplifier le courant des quasi particules (7') passant par effet tunnel à travers la jonction (15).

8. Capteur selon la revendication 7, caractérisé en ce qu'il comporte des convertisseurs analogiques numériques (24) assurant la numérisation des signaux délivrés par les amplificateurs (23) et des moyens (25) de traitement et/ou de stockage du signal numérisé.

9. Capteur selon la revendication 8, caractérisé en ce qu'il comporte des moyens de codage (27) délivrant pour chaque valeur numérique l'intensité du signal délivré par un amplificateur (23), une information concernant la position de la jonction supraconductrice à effet tunnel (15) concernée, le temps de réception et la valeur de l'intensité de courant amplifiée.

10. Capteur selon l'une quelconque des revendications 7 à 9, caractérisé en ce qu'il comporte des moyens (45, 50, 23) de mise en forme du signal et des moyens de calcul (28) de détermination d'après la forme du signal transmis par les moyens de mise en forme du signal de la charge induite par le photon à détecter (9) dans la jonction supraconductrice à effet tunnel (15).

11. Capteur selon l'une quelconque des revendications 7 à 10, caractérisé en ce qu'il comporte des moyens (56, 57) d'échantillonnage du signal sur des intervalles de temps correspondant à la détection des photons successifs et des moyens (28) pour en déduire l'énergie individuelle de chacun des photons.

12. Capteur selon l'une quelconque des revendications 7 à 11, caractérisé en ce qu'il comporte des moyens (59) d'intégration de la charge induite dans une jonction supraconductrice à effet tunnel (15) par une pluralité de photons.

13. Spectroscope, caractérisé en ce qu'il comporte un capteur selon la revendication 7 à 12.

**Claims**

1. A cell for detecting photons, the cell comprising a superconducting element (14) made of niobium, that is sensitive to a photon (9) of the radiation to be detected, or to phonons (10) generated by such a photon (9) by breaking Cooper pairs (8) into quasi-particles (7') and by means of a superconducting tunnel junction (15) including a superconducting electrode (17), at the operating temperature of the cell, the photosensitive superconducting element having characteristics of energy gap ($2\Delta$) and of thickness that enable the energy of each quasi-particle (7') coming from a broken Cooper pair (8) to be reduced while multiplying the number of quasi-particles by a factor lying in the range 100 to 1000 in a spectrum extending from near infrared to ultraviolet, and the cell being delimited by a plurality of spaced-apart superconducting tunnel junctions (15) distributed around the periphery of the cell (21), the cell being characterized in that it includes walls (19) around its periphery and terminating at the superconducting tunnel junctions (15), the walls being made of superconducting material, i.e. Al, having an energy gap $2\Delta_2$ that is less than the energy gap $2\Delta_1$ of the material of the sensitive element (14), such that said walls (19) form channels for channelling the quasi-particles (7') towards the superconducting tunnel junctions (15), and the number of quasi-particles (7') increases after a quasi-particle (7') has tunnelled from the sensitive elements (14) into a wall (19).

2. A cell according to claim 1, characterized in that its walls (19) include discontinuities (22), preferably halfway between two adjacent superconducting tunnel junctions (15).

3. A cell according to any preceding claim, characterized in that the sensitive element (14) is of small thickness and is deposited on a substrate (18) that is transparent to the electromagnetic radiation to be sensed.

4. A cell according to claim 3, characterized in that it includes a thin layer (20) that absorbs the radiation to be sensed, said layer (20) being disposed between the support (18) and the sensitive element (14).

5. A cell according to any preceding claim, characterized in that the superconducting tunnel junction (15) is made of aluminum covered by a niobium electrode-bonding layer (17, 14').

6. A detector characterized in that it comprises a plurality of cells (21) according to any preceding claim, in particular a linear detector comprising cells (21) aligned along an axis, or a matrix detector comprising cells (21) aligned along rows and columns.

7. A sensor including a cell according to any one of claims 1 to 5, or a detector according to claim 6, characterized in that it includes a low-noise amplifier (23) connected to each superconducting tunnel junction (15) to amplify the current of quasi-particles (7') tunnelling through the junction (15).

8. A sensor according to claim 7, characterized in that it includes analog-to-digital converters (24) for digitizing the signals delivered by the amplifiers (23), and means (25) for processing and/or storing the digitized signals.

9. A sensor according to claim 8, characterized in that it includes encoding means (27) responding to each digitized value of the signal delivered by an amplifier (23) by delivering information relating to the position of the corresponding superconducting tunnel junction (15), the time of reception, and the value of the amplified current.

10. A sensor according to any one of claims 7 to 9, characterized in that it includes signal-shaping means (45, 50, 23) and computer means (28) for determining the charge induced in the superconducting tunnel junction (15) by the photon to be detected (9) on the basis of the shape of the signal transmitted by the signal-shaping means.

11. A sensor according to any one of claims 7 to 10, characterized in that it includes means (56, 57) for sampling the signal over time intervals that correspond to the detection of successive photons, and means (28) for deducing therefrom the individual energy of each of the photons.

12. A sensor according to any one of claims 7 to 11, characterized in that it includes means (59) for integrating the charge induced in a superconducting tunnel junction (15) by a plurality of photons.

13. A spectroscope, characterized in that it includes a sensor according to any one of claims 7 to 12.

**Patentansprüche**

1. Photonendetektorzelle mit einem supraleitenden Element (14) aus Niob, das das Photon (9) der zu erfassenden Strahlung oder die Phonone (10) misst, die durch ein solches Photon (9) erzeugt werden, durch Aufteilung des Cooperpaars (8) in Quasiteilchen (7') und einen supraleitenden Übergang mit Tunneleffekt (15), der eine supraleitende Elektrode (17) umfasst, wobei das supraleitende photosensible Element, das Eigenschaften zur Betriebstemperatur, der unzulässigen Bandbreite des Anregungsspektrums (2Δ) und der Dicke hat, eine Energiesenkung jedes Quasiteilchens (7') zulässt, das aus dem Cooperpaar (8) hervorgegangen ist, das unter Multiplikation der Anzahl an Quasiteilchen mit einem zwischen 100 und 1000 im Spektrum vom nahen Infrarot bis Ultraviolett liegenden Faktor aufgebrochen wird, und wobei die Zelle durch mehrere beabstandete supraleitende Übergänge mit Tunneleffekt (15) begrenzt ist, die auf dem Zellenumfang (21) verteilt sind, dadurch gekennzeichnet, dass die Zelle am Umfang Wände (19) aufweist, die an die supraleitenden Übergänge mit Tunneleffekt (15) angrenzen, und ein supraleitendes Material, d. h. Al, dessen unzulässige Bandbreite des Anregungsspektrums 2Δ2 kleiner ist als die unzulässige Bandbreite des Anregungsspektrums 2Δ1 des Materials des sensiblen Elements (14), so dass die Wände (19) Kanäle bilden, um die Quasiteilchen (7') zu den supraleitenden Übergängen mit Tunneleffekt (15) zu leiten, und dass die Anzahl der Quasiteilchen (7') nach dem Durchgang eines Quasiteilchens (7') des sensiblen Elements (14) in einer Wand (19) ansteigt.

2. Zelle nach Anspruch 1, dadurch gekennzeichnet, dass die Wände (19) Unterbrechungen (22) aufweisen, vorzugsweise auf halber Entfernung zwischen zwei benachbarten supraleitenden Übergängen mit Tunneleffekt (15).

3. Zelle nach einem der vorhergehenden Ansprüche, dadurch gekennzeichnet, dass das sensible Element (14) eine geringe Dicke hat und auf einem Substrat (18) untergebracht ist, das für die zu erfassende elektromagnetische Strahlung durchlässig ist.

4. Zelle nach Anspruch 3, dadurch gekennzeichnet, dass sie eine Schicht (20) geringer Dicke umfasst, die die zu erfassende Strahlung absorbiert, wobei die Schicht (20) zwischen dem Träger (18) und dem sensiblen Element (14) angeordnet ist.

5. Zelle nach einem der vorhergehenden Ansprüche, dadurch gekennzeichnet, dass der supraleitende Übergang mit Tunneleffekt (15) aus Aluminium besteht, das mit einer Elektrodenbefestigungsschicht aus Niob (17, 14') beschichtet ist.

6. Detektor, dadurch gekennzeichnet, dass er mehrere Zellen (21) nach einem der vorhergehenden Ansprüche umfasst, insbesondere linearer Detektor mit in einer Achse ausgerichteten Zellen (21) oder Matrixdetektor mit in Zeilen und Spalten ausgerichteten Zellen (21).

7. Sensor mit einer Zelle nach einem der Ansprüche 1 bis 5 oder einem Detektor nach Anspruch 6, dadurch gekennzeichnet, dass er einen geräuscharmen Verstärker (23) umfasst, der mit jedem supraleitenden Übergang mit Tunneleffekt (15) verbunden ist, um den Strom der Quasiteilchen (7') zu verstärken, die durch den Tunneleffekt den Übergang (15) passieren.

8. Sensor nach Anspruch 7, dadurch gekennzeichnet, dass er Analog-Digital-Umsetzer (24) umfasst, um die von den Verstärkern (23) abgegebenen Signale zu digitalisieren, und Mittel (25) zur Bearbeitung und/oder Speicherung des digitalisierten Signals.

9. Sensor nach Anspruch 8, dadurch gekennzeichnet, dass er Codierungsmittel (27) umfasst, die für jeden digitalen Wert die Stärke des von einem Verstärker (23) abgegebenen Signals, eine Angabe über die Lage des betreffenden supraleitenden Übergangs mit Tunneleffekt (15), die Empfangszeit und die Stärke des verstärkten Stroms liefern.

10. Sensor nach einem der Ansprüche 7 bis 9, dadurch gekennzeichnet, dass er Mittel zur Signalumformung (45, 50, 23) umfasst und Berechnungsmittel (28), um nach der von den Mitteln zur Signalumformung gesendeten Signalform die vom zu erfassenden Photon (9) in den supraleitenden Übergang mit Tunneleffekt (15) induzierte Last zu bestimmen.

11. Sensor nach einem der Ansprüche 7 bis 10, dadurch gekennzeichnet, dass er Mittel zur Signalabtastung (56, 57) in Zeitintervallen umfasst, die der Erfassung der aufeinanderfolgenden Photonen entsprechen, und Mittel (28), um daraus die individuelle Energie jedes einzelnen Photons abzuleiten.

12. Sensor nach einem der Ansprüche 7 bis 11, dadurch gekennzeichnet, dass er Mittel (59) zur Integration der durch mehrere Photonen in einen supraleitenden Übergang mit Tunneleffekt (15) induzierten Last umfasst.

13. Spektroskop, dadurch gekennzeichnet, dass es einen Sensor nach Anspruch 7 bis 12 umfasst.

*FIG.1*

*FIG.11*

*FIG.12*

FIG.2

FIG.3

FIG.4

FIG.5

FIG.6

FIG.7

FIG.8

FIG.9

FIG.10

FIG.13

*FIG.14*

*FIG.15*

*FIG.16*

*FIG.17*

*FIG.18*

*FIG.19a*

*FIG.19b*

*FIG.19c*

57.1

Amplificateur de charge | élimination de pôles | échantilloneur

15

54    55

57.2

échantilloneur

23

57.3

échantilloneur

FIG.20

COMMANDE

56

I

$t_{11}$ $t_{12}$    $t_{22}$ $t_{32}$

$t_{21}$ $t_{31}$

t

FIG.21a

C

$t_{31}$ $t_{32}$

$t_{11}$ $t_{12}$    $t_{21}$ $t_{22}$    $t_3$

t

FIG.21b

A

t

FIG.21c

58.1

t

58.2

t

FIG.22

58.3

t

*FIG.23*

*FIG.24a*

*FIG.24b*

*FIG.24c*

*FIG.25*

65

66

0.30  0.10  0  -0.10  -0.30

I  0.003  0.001  0  -0.001  -0.003

FIG.26

FIG.27

FIG.28

EP 0 593 333 B1

*FIG.29*